# EUROPEAN PATENT APPLICATION

(11) **EP 4 707 229 A2**
(43) Date of publication of application: **11.03.2026**
(21) Application number: 26152403.7
(22) Date of filing: 03.12.2021
(51) Int. Cl.: B82Y 10/00

(54) **PARAMETRIC AMPLIFICATION IN A QUANTUM COMPUTING SYSTEM**

(30) Priority: 03.12.2020 US 202063121099 P
(62) Divisional of application: 21901529.4
(71) Applicant: Rigetti & Co, LLC, Berkeley, CA 94710 (US)
(72) Inventor: SELVANAYAGAM,, Michael Karunendra, Berkeley, 94710 (US); RAMACHANDRAN,, Ganesh, Berkeley, 94710 (US); MOHAN,, Yuvraj, Berkeley, 94710 (US); SHARAC,, Nicholas Warren, Berkeley, 94710 (US); FENG,, Dennis Chen, Berkeley, 94710 (US); VAHIDPOUR,, Mehrnoosh, Berkeley, 94710 (US)
(74) Representative: Potter Clarkson

(57) **Abstract**

In a general aspect, parametric amplification is performed in a quantum computing system. In some cases, a traveling wave parametric amplifier (TWPA) includes a plurality of Josephson junctions connected in series. The plurality of Josephson junctions includes a first Josephson junction, which includes a first superconducting electrode on a surface of a substrate, a second superconducting electrode that overlaps the first superconducting electrode, and a barrier sandwiched between overlapping sections of the first and second superconducting electrodes. The barrier defines a footprint with a tapered shape over the surface of the substrate.

## Description

### CROSS-REFERENCE TO RELATED APPLICATIONS

This application claims priority to U.S. Provisional Application No. 63/121,099 filed on December 3, 2020, entitled "Parametric Amplification in a Quantum Computing System." The above-referenced priority application is hereby incorporated by reference.

### BACKGROUND

The following description relates to parametric amplification in a quantum computing system.

Quantum computers can perform computational tasks by storing and processing information within quantum states of quantum systems. For example, qubits (i.e., quantum bits) can be stored in and represented by an effective two-level sub-manifold of a quantum coherent physical system. A variety of physical systems have been proposed for quantum computing applications. Examples include superconducting circuits, trapped ions, spin systems and others.

### BRIEF DESCRIPTION OF THE DRAWINGS

FIG. 1 is a block diagram of an example computing system.
FIG. 2A is a schematic diagram showing aspects of an example traveling wave parametric amplifier (TWPA).
FIG. 2B is a top view of an example unit cell in the traveling wave parametric amplifier (TWPA) shown in FIG. 2A.
FIG. 2C is a side cross-sectional view of an example unit cell in the traveling wave parametric amplifier (TWPA) shown in FIG. 2A.
FIG. 3 is a flow chart showing aspects of an example fabrication process.
FIG. 4 is a schematic diagram showing aspects of an example traveling wave parametric amplifier (TWPA).
FIG. 5 is a diagram showing an equivalent circuit representing circuit components between two probe pads in the example traveling wave parametric amplifier (TWPA) shown in FIG. 4.
FIG. 6 is a block diagram showing aspects of an example cryostat in a quantum computing system.
FIG. 7A is a block diagram showing aspects of an example microwave payload circuit.
FIG. 7B is a block diagram showing aspects of an example microwave payload circuit.
FIG. 8 is a block diagram showing aspects of an example circuit module.
FIG. 9 is a block diagram showing aspects of an example diplexer.
FIG. 10 is a block diagram showing aspects of an example isolator.
FIG. 11A is a plot showing simulated S-parameters of an example diplexer.
FIGS. 11B and 11C are plots showing simulated S-parameters of an example microwave payload circuit shown in FIG. 7A.

### DETAILED DESCRIPTION

In some aspects of what is described here, a quantum computing system includes a parametric amplifier for amplifying readout signals from, and feedback control signals to, qubits in a quantum processing unit. The parametric amplifier can be implemented as a traveling wave parametric amplifier (TWPA) with Josephson junctions embedded in a transmission medium, which forms a non-linear medium. In some instances, when a weak signal (e.g., a readout signal from a qubit device) and a strong pump signal are applied on the nonlinear medium, the wave-mixing interaction causes the weak signal to be amplified.

In some implementations, the transmission medium in the TWPA is a coplanar waveguide fabricated on a surface of a substrate, and the Josephson junctions are connected in series along the central conductive strip of the coplanar waveguide. In some implementations, one or more of the Josephson junctions in the TWPA defines a footprint with a tapered shape where the width of the shape reduces toward one end, such as a triangular footprint, over the surface of the substrate and with two superconducting electrodes oriented along the central conductive strip of the coplanar waveguide. The tapered edges of the tapered shape may be straight or curved, when curved they may be concave, convex or both. Furthermore, the tapered edges of the tapered shape may be stepped, pixelated, or irregular. Yet furthermore the tapered edges of the tapered shape may be different to each other, where one of the tapered edges is straight and the other curved, or any other combination chosen from the aforementioned options. The apex of the tapered shape may be sharp, rounded, flat or truncated. In some implementations, the methods and systems presented here can reduce the exposure of the Josephson junction to ambient environment, during fabrication and/or after fabrication, which can cause contamination and uncontrolled oxidation to a barrier layer sandwiched between the two superconducting electrodes, and thus, improve the stability of the Josephson junctions and the TWPA. In certain instances, the methods and systems presented here can reduce fabrication steps of the TWPA and improve yield of Josephson junctions in the TWPA. Further, the methods and systems presented here may provide accurate resistance targeting, which can improve the impedance matching and gain properties of the TWPA. In some instances, the methods and systems presented here provide a simplified fabrication process of a TWPA. For example, the methods and systems do not require separate steps for fabricating orthogonal leads for respective superconducting electrodes of the Josephson junction and for conductive patches that further connect the orthogonal leads to a planar waveguide to form the TWPA.

In some aspects of what is described here, a TWPA includes probe pads galvanically coupled to the central conductive strip of the coplanar waveguide. The probe pads can be used to characterize one or more Josephson junctions or another circuit component along the TWPA. The methods and systems disclosed here can provide advantages, such as allowing for characterizing and screening of TWPAs at room temperature prior to the measurement in cryogenic environment.

In some aspects of what is described here, a TWPA can be used in a microwave payload circuit as part of a control system. The microwave payload circuit may further include two diplexers to reduce the use of expensive circulators or isolators and thus reduce the cost associated with including such a circuit in a quantum computing system. In some implementations, the diplexers and the TWPA can be manufactured on the same semiconductor substrate, manufactured separately, and integrated on a substrate, e.g., a printed circuit board (PCB), or in another manner, to form an integrated module. Therefore, the method and systems presented here can also reduce the use of bulky circuit components and thus do not limit the number of readout channels that can be accommodated in a dilution refrigerator.

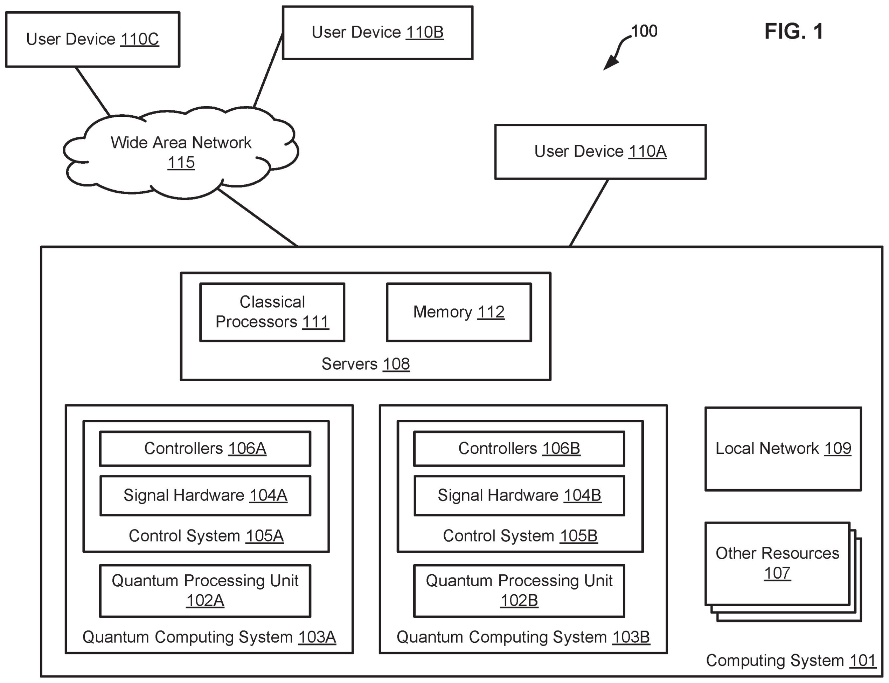

FIG. 1 is a block diagram of an example computing environment 100. The example computing environment 100 shown in FIG. 1 includes a computing system 101 and user devices 110A, 110B, 110C. A computing environment may include additional or different features, and the components of a computing environment may operate as described with respect to FIG. 1 or in another manner.

The example computing system 101 includes classical and quantum computing resources and exposes their functionality to the user devices 110A, 110B, 110C (referred to collectively as "user devices 110"). The computing system 101 shown in FIG. 1 includes one or more servers 108, quantum computing systems 103A, 103B, a local network 109, and other resources 107. The computing system 101 may also include one or more user devices (e.g., the user device 110A) as well as other features and components. A computing system may include additional or different features, and the components of a computing system may operate as described with respect to FIG. 1 or in another manner.

The example computing system 101 can provide services to the user devices 110, for example, as a cloud-based or remote-accessed computer system, as a distributed computing resource, as a supercomputer or another type of high-performance computing resource, or in another manner. The computing system 101 or the user devices 110 may also have access to one or more other quantum computing systems (e.g., quantum computing resources that are accessible through the wide area network 115, the local network 109 or otherwise).

The user devices 110 shown in FIG. 1 may include one or more classical processor, memory, user interfaces, communication interfaces, and other components. For instance, the user devices 110 may be implemented as laptop computers, desktop computers, smartphones, tablets, or other types of computer devices. In the example shown in FIG. 1, to access computing resources of the computing system 101, the user devices 110 send information (e.g., programs, instructions, commands, requests, input data, etc.) to the servers 108; and in response, the user devices 110 receive information (e.g., application data, output data, prompts, alerts, notifications, results, etc.) from the servers 108. The user devices 110 may access services of the computing system 101 in another manner, and the computing system 101 may expose computing resources in another manner.

In the example shown in FIG. 1, the local user device 110A operates in a local environment with the servers 108 and other elements of the computing system 101. For instance, the user device 110A may be co-located with (e.g., located within 0.5 to 1 km of) the servers 108 and possibly other elements of the computing system 101. As shown in FIG. 1, the user device 110A communicates with the servers 108 through a local data connection.

The local data connection in FIG. 1 is provided by the local network 109. For example, some or all of the servers 108, the user device 110A, the quantum computing systems 103A, 103B and the other resources 107 may communicate with each other through the local network 109. In some implementations, the local network 109 operates as a communication channel that provides one or more low-latency communication pathways from the server 108 to the quantum computer systems 103A, 103B (or to one or more of the elements of the quantum computer systems 103A, 103B). The local network 109 can be implemented, for instance, as a wired or wireless Local Area Network, an Ethernet connection, or another type of wired or wireless connection. The local network 109 may include one or more wired or wireless routers, wireless access points (WAPs), wireless mesh nodes, switches, high-speed cables, or a combination of these and other types of local network hardware elements. In some cases, the local network 109 includes a software-defined network that provides communication among virtual resources, for example, among an array of virtual machines operating on the server 108 and possibly elsewhere.

In the example shown in FIG. 1, the remote user devices 110B, 110C operate remote from the servers 108 and other elements of the computing system 101. For instance, the user devices 110B, 110C may be located at a remote distance (e.g., more than 1 km, 10 km, 100 km, 1,000 km, 10,000 km, or farther) from the servers 108 and possibly other elements of the computing system 101. As shown in FIG. 1, each of the user devices 110B, 110C communicates with the servers 108 through a remote data connection.

The remote data connection in FIG. 1 is provided by a wide area network 115, which may include, for example, the Internet or another type of wide area communication network. In some cases, remote user devices use another type of remote data connection (e.g., satellite-based connections, a cellular network, a virtual private network, etc.) to access the servers 108. The wide area network 115 may include one or more internet servers, firewalls, service hubs, base stations, or a combination of these and other types of remote networking elements. Generally, the computing environment 100 can be accessible to any number of remote user devices.

The example servers 108 shown in FIG. 1 can manage interaction with the user devices 110 and utilization of the quantum and classical computing resources in the computing system 101. For example, based on information from the user devices 110, the servers 108 may delegate computational tasks to the quantum computing systems 103A, 103B and the other resources 107; the servers 108 can then send information to the user devices 110 based on output data from the computational tasks performed by the quantum computing systems 103A, 103B and the other resources 107.

As shown in FIG. 1, the servers 108 are classical computing resources that include classical processors 111 and memory 112. The servers 108 may also include one or more communication interfaces that allow the servers to communicate via the local network 109, the wide area network 115 and possibly other channels. In some implementations, the servers 108 may include a host server, an application server, a virtual server or a combination of these and other types of servers. The servers 108 may include additional or different features, and may operate as described with respect to FIG. 1 or in another manner.

The classical processors 111 can include various kinds of apparatus, devices, and machines for processing data, including, by way of example, a microprocessor, a central processing unit (CPU), a graphics processing unit (GPU), an FPGA (field programmable gate array), an ASIC (application specific integrated circuit), or combinations of these. The memory 112 can include, for example, a random-access memory (RAM), a storage device (e.g., a writable read-only memory (ROM) or others), a hard disk, or another type of storage medium. The memory 112 can include various forms of volatile or non-volatile memory, media, and memory devices, etc.

Each of the example quantum computing systems 103A, 103B operates as a quantum computing resource in the computing system 101. The other resources 107 may include additional quantum computing resources (e.g., quantum computing systems, quantum virtual machines (QVMs) or quantum simulators) as well as classical (non-quantum) computing resources such as, for example, digital microprocessors, specialized co-processor units (e.g., graphics processing units (GPUs), cryptographic co-processors, etc.), special purpose logic circuitry (e.g., field programmable gate arrays (FPGAs), application-specific integrated circuits (ASICs), etc.), systems-on-chips (SoCs), etc., or combinations of these and other types of computing modules.

In some implementations, the servers 108 generate programs, identify appropriate computing resources (e.g., a QPU or QVM) in the computing system 101 to execute the programs, and send the programs to the identified resources for execution. For example, the servers 108 may send programs to the quantum computing system 103A, the quantum computing system 103B or any of the other resources 107. The programs may include classical programs, quantum programs, hybrid classical/quantum programs, and may include any type of function, code, data, instruction set, etc.

In some instances, programs can be formatted as source code that can be rendered in human-readable form (e.g., as text) and can be compiled, for example, by a compiler running on the servers 108, on the quantum computing systems 103, or elsewhere. In some instances, programs can be formatted as compiled code, such as, for example, binary code (e.g., machine-level instructions) that can be executed directly by a computing resource. Each program may include instructions corresponding to computational tasks that, when performed by an appropriate computing resource, generate output data based on input data. For example, a program can include instructions formatted for a quantum computer system, a quantum virtual machine, a digital microprocessor, co-processor or other classical data processing apparatus, or another type of computing resource.

In some cases, a program may be expressed in a hardware-independent format. For example, quantum machine instructions may be provided in a quantum instruction language such as Quil, described in the publication "A Practical Quantum Instruction Set Architecture," arXiv:1608.03355v2, dated Feb. 17, 2017, or another quantum instruction language. For instance, the quantum machine instructions may be written in a format that can be executed by a broad range of quantum processing units or quantum virtual machines. In some cases, a program may be expressed in high-level terms of quantum logic gates or quantum algorithms, in lower-level terms of fundamental qubit rotations and controlled rotations, or in another form. In some cases, a program may be expressed in terms of control signals (e.g., pulse sequences, delays, etc.) and parameters for the control signals (e.g., frequencies, phases, durations, channels, etc.). In some cases, a program may be expressed in another form or format.

In some implementations, the servers 108 include one or more compilers that convert programs between formats. For example, the servers 108 may include a compiler that converts hardware-independent instructions to binary programs for execution by the quantum computing systems 103A, 103B. In some cases, a compiler can compile a program to a format that targets a specific quantum resource in the computer system 101. For example, a compiler may generate a different binary program (e.g., from the same source code) depending on whether the program is to be executed by the quantum computing system 103A or the quantum computing system 103B.

In some cases, a compiler generates a partial binary program that can be updated, for example, based on specific parameters. For instance, if a quantum program is to be executed iteratively on a quantum computing system with varying parameters on each iteration, the compiler may generate the binary program in a format that can be updated with specific parameter values at runtime (e.g., based on feedback from a prior iteration, or otherwise). In some cases, a compiler generates a full binary program that does not need to be updated or otherwise modified for execution.

In some implementations, the servers 108 generate a schedule for executing programs, allocate computing resources in the computing system 101 according to the schedule, and delegate the programs to the allocated computing resources. The servers 108 can receive, from each computing resource, output data from the execution of each program. Based on the output data, the servers 108 may generate additional programs that are then added to the schedule, output data that is provided back to a user device 110, or perform another type of action.

In some implementations, all or part of the computing environment operates as a cloud-based quantum computing (QC) environment, and the servers 108 operate as a host system for the cloud-based QC environment. The cloud-based QC environment may include software elements that operate on both the user devices 110 and the computer system 101 and interact with each other over the wide area network 115. For example, the cloud-based QC environment may provide a remote user interface, for example, through a browser or another type of application on the user devices 110. The remote user interface may include, for example, a graphical user interface or another type of user interface that obtains input provided by a user of the cloud-based QC environment. In some cases the remote user interface includes, or has access to, one or more application programming interfaces (APIs), command line interfaces, graphical user interfaces, or other elements that expose the services of the computer system 101 to the user devices 110.

In some cases, the cloud-based QC environment may be deployed in a "serverless" computing architecture. For instance, the cloud-based QC environment may provide on-demand access to a shared pool of configurable computing resources (e.g., networks, servers, storage, applications, services, quantum computing resources, classical computing resources, etc.) that can be provisioned for requests from user devices 110. Moreover, the cloud-based computing systems 104 may include or utilize other types of computing resources, such as, for example, edge computing, fog computing, etc.

In an example implementation of a cloud-based QC environment, the servers 108 may operate as a cloud provider that dynamically manages the allocation and provisioning of physical computing resources (e.g., GPUs, CPUs, QPUs, etc.). Accordingly, the servers 108 may provide services by defining virtualized resources for each user account. For instance, the virtualized resources may be formatted as virtual machine images, virtual machines, containers, or virtualized resources that can be provisioned for a user account and configured by a user. In some cases, the cloud-based QC environment is implemented using a resource such as, for example, OPENSTACK ^{®}. OPENSTACK ^{®} is an example of a software platform for cloud-based computing, which can be used to provide virtual servers and other virtual computing resources for users.

In some cases, the server 108 stores quantum machine images (QMI) for each user account. A quantum machine image may operate as a virtual computing resource for users of the cloud-based QC environment. For example, a QMI can provide a virtualized development and execution environment to develop and run programs (e.g., quantum programs or hybrid classical/quantum programs). When a QMI operates on the server 108, the QMI may engage either of the quantum processor units 102A, 102B, and interact with a remote user device (110B or 110C) to provide a user programming environment. The QMI may operate in close physical proximity to and have a low-latency communication link with the quantum computing systems 103A, 103B. In some implementations, remote user devices connect with QMIs operating on the servers 108 through secure shell (SSH) or other protocols over the wide area network 115.

In some implementations, all or part of the computing system 101 operates as a hybrid computing environment. For example, quantum programs can be formatted as hybrid classical/quantum programs that include instructions for execution by one or more quantum computing resources and instructions for execution by one or more classical resources. The servers 108 can allocate quantum and classical computing resources in the hybrid computing environment, and delegate programs to the allocated computing resources for execution. The quantum computing resources in the hybrid environment may include, for example, one or more quantum processing units (QPUs), one or more quantum virtual machines (QVMs), one or more quantum simulators, or possibly other types of quantum resources. The classical computing resources in the hybrid environment may include, for example, one or more digital microprocessors, one or more specialized co-processor units (e.g., graphics processing units (GPUs), cryptographic co-processors, etc.), special purpose logic circuitry (e.g., field programmable gate arrays (FPGAs), application-specific integrated circuits (ASICs), etc.), systems-on-chips (SoCs), or other types of computing modules.

In some cases, the servers 108 can select the type of computing resource (e.g., quantum or classical) to execute an individual program, or part of a program, in the computing system 101. For example, the servers 108 may select a particular quantum processing unit (QPU) or other computing resource based on availability of the resource, speed of the resource, information or state capacity of the resource, a performance metric (e.g., process fidelity) of the resource, or based on a combination of these and other factors. In some cases, the servers 108 can perform load balancing, resource testing and calibration, and other types of operations to improve or optimize computing performance.

Each of the example quantum computing systems 103A, 103B shown in FIG. 1 can perform quantum computational tasks by executing quantum machine instructions (e.g., a binary program compiled for the quantum computing system). In some implementations, a quantum computing system can perform quantum computation by storing and manipulating information within quantum states of a composite quantum system. For example, qubits (i.e., quantum bits) can be stored in and represented by an effective two-level sub-manifold of a quantum coherent physical system. In some instances, quantum logic can be executed in a manner that allows large-scale entanglement within the quantum system. Control signals can manipulate the quantum states of individual qubits and the joint states of multiple qubits. In some instances, information can be read out from the composite quantum system by measuring the quantum states of the qubits. In some implementations, the quantum states of the qubits are read out by measuring the transmitted or reflected signal from auxiliary quantum devices that are coupled to individual qubits.

In some implementations, a quantum computing system can operate using gate-based models for quantum computing. For example, the qubits can be initialized in an initial state, and a quantum logic circuit comprised of a series of quantum logic gates can be applied to transform the qubits and extract measurements representing the output of the quantum computation. Individual qubits may be controlled by single-qubit quantum logic gates, and pairs of qubits may be controlled by two-qubit quantum logic gates (e.g., entangling gates that are capable of generating entanglement between the pair of qubits). In some implementations, a quantum computing system can operate using adiabatic or annealing models for quantum computing. For instance, the qubits can be initialized in an initial state, and the controlling Hamiltonian can be transformed adiabatically by adjusting control parameters to another state that can be measured to obtain an output of the quantum computation.

In some models, fault-tolerance can be achieved by applying a set of high-fidelity control and measurement operations to the qubits. For example, quantum error correcting schemes can be deployed to achieve fault-tolerant quantum computation. Other computational regimes may be used; for example, quantum computing systems may operate in non-fault-tolerant regimes. In some implementations, a quantum computing system is constructed and operated according to a scalable quantum computing architecture. For example, in some cases, the architecture can be scaled to a large number of qubits to achieve large-scale general-purpose coherent quantum computing. Other architectures may be used; for example, quantum computing systems may operate in small-scale or non-scalable architectures.

The example quantum computing system 103A shown in FIG. 1 includes a quantum processing unit 102A and a control system 105A, which controls the operation of the quantum processing unit 102A. Similarly, the example quantum computing system 103B includes a quantum processing unit 102B and a control system 105B, which controls the operation of a quantum processing unit 102B. A quantum computing system may include additional or different features, and the components of a quantum computing system may operate as described with respect to FIG. 1 or in another manner.

In some instances, all or part of the quantum processing unit 102A functions as a quantum processor, a quantum memory, or another type of subsystem. In some examples, the quantum processing unit 102A includes a quantum circuit system. The quantum circuit system may include qubit devices, readout devices, and possibly other devices that are used to store and process quantum information. In some cases, the quantum processing unit 102A includes a superconducting circuit, and the qubit devices are implemented as circuit devices that include Josephson junctions, for example, in superconducting quantum interference device (SQUID) loops or other arrangements, and are controlled by radio-frequency signals, microwave signals, and bias signals delivered to the quantum processing unit 102A. In some cases, the quantum processing unit 102A includes an ion trap system, and the qubit devices are implemented as trapped ions controlled by optical signals delivered to the quantum processing unit 102A. In some cases, the quantum processing unit 102A includes a spin system, and the qubit devices are implemented as nuclear or electron spins controlled by microwave or radio-frequency signals delivered to the quantum processing unit 102A. The quantum processing unit 102A may be implemented based on another physical modality of quantum computing.

The quantum processing unit 102A may include, or may be deployed within, a controlled environment. The controlled environment can be provided, for example, by shielding equipment, cryogenic equipment, and other types of environmental control systems. In some examples, the components in the quantum processing unit 102A operate in a cryogenic temperature regime and are subject to very low electromagnetic and thermal noise. For example, magnetic shielding can be used to shield the system components from stray magnetic fields, optical shielding can be used to shield the system components from optical noise, and thermal shielding and cryogenic equipment can be used to maintain the system components at controlled temperature, etc.

In some implementations, the example quantum processing unit 102A can process quantum information by applying control signals to the qubits in the quantum processing unit 102A. The control signals can be configured to encode information in the qubits, to process the information by performing quantum logic gates or other types of operations, or to extract information from the qubits. In some examples, the operations can be expressed as single-qubit quantum logic gates, two-qubit quantum logic gates, or other types of quantum logic gates that operate on one or more qubits. A quantum logic circuit, which includes a sequence of quantum logic operations, can be applied to the qubits to perform a quantum algorithm. The quantum algorithm may correspond to a computational task, a hardware test, a quantum error correction procedure, a quantum state distillation procedure, or a combination of these and other types of operations.

The example control system 105A includes controllers 106A and signal hardware 104A. Similarly, control system 105B includes controllers 106B and signal hardware 104B. All or part of the control systems 105A, 105B can operate in a room-temperature environment or another type of environment, which may be located near the respective quantum processing units 102A, 102B. In some cases, the control systems 105A, 105B include classical computers, signaling equipment (microwave, radio, optical, bias, etc.), electronic systems, vacuum control systems, refrigerant control systems or other types of control systems that support operation of the quantum processing units 102A, 102B.

The control systems 105A, 105B may be implemented as distinct systems that operate independent of each other. In some cases, the control systems 105A, 105B may include one or more shared elements; for example, the control systems 105A, 105B may operate as a single control system that operates both quantum processing units 102A, 102B. Moreover, a single quantum computer system may include multiple quantum processing units, which may operate in the same controlled (e.g., cryogenic) environment or in separate environments.

The example signal hardware 104A includes components that communicate with the quantum processing unit 102A. The signal hardware 104A may include, for example, waveform generators, amplifiers, digitizers, high-frequency sources, DC sources, AC sources, etc. The signal hardware may include additional or different features and components. In the example shown, components of the signal hardware 104A are adapted to interact with the quantum processing unit 102A. For example, the signal hardware 104A can be configured to operate in a particular frequency range, configured to generate and process signals in a particular format, or the hardware may be adapted in another manner.

In some instances, one or more components of the signal hardware 104A generate control signals, for example, based on control information from the controllers 106A. The control signals can be delivered to the quantum processing unit 102A during operation of the quantum computing system 103A. For instance, the signal hardware 104A may generate signals to implement quantum logic operations, readout operations, or other types of operations. As an example, the signal hardware 104A may include arbitrary waveform generators (AWGs) that generate electromagnetic waveforms (e.g., microwave or radio-frequency) or laser systems that generate optical waveforms. The waveforms or other types of signals generated by the signal hardware 104A can be delivered to devices in the quantum processing unit 102A to operate qubit devices, readout devices, bias devices, coupler devices, or other types of components in the quantum processing unit 102A.

In some instances, the signal hardware 104A receives and processes signals from the quantum processing unit 102A. The received signals can be generated by the execution of a quantum program on the quantum computing system 103A. For instance, the signal hardware 104A may receive signals from the devices in the quantum processing unit 102A in response to readout or other operations performed by the quantum processing unit 102A. Signals received from the quantum processing unit 102A can be mixed, digitized, filtered, or otherwise processed by the signal hardware 104A to extract information, and the information extracted can be provided to the controllers 106A or handled in another manner. In some examples, the signal hardware 104A may include a digitizer that digitizes electromagnetic waveforms (e.g., microwave or radio-frequency) or optical signals, and a digitized waveform can be delivered to the controllers 106A or to other signal hardware components. In some instances, the controllers 106A process the information from the signal hardware 104A and provide feedback to the signal hardware 104A; based on the feedback, the signal hardware 104A can in turn generate new control signals that are delivered to the quantum processing unit 102A.

In some implementations, the signal hardware 104A includes signal delivery hardware that interfaces with the quantum processing unit 102A. For example, the signal hardware 104A may include filters, attenuators, directional couplers, multiplexers, diplexers, bias components, signal channels, isolators, amplifiers, power dividers, and other types of components. In some instances, the signal delivery hardware performs preprocessing, signal conditioning, or other operations to the control signals to be delivered to the quantum processing unit 102A. In some instances, signal delivery hardware performs preprocessing, signal conditioning, or other operations on readout signals received from the quantum processing unit 102A.

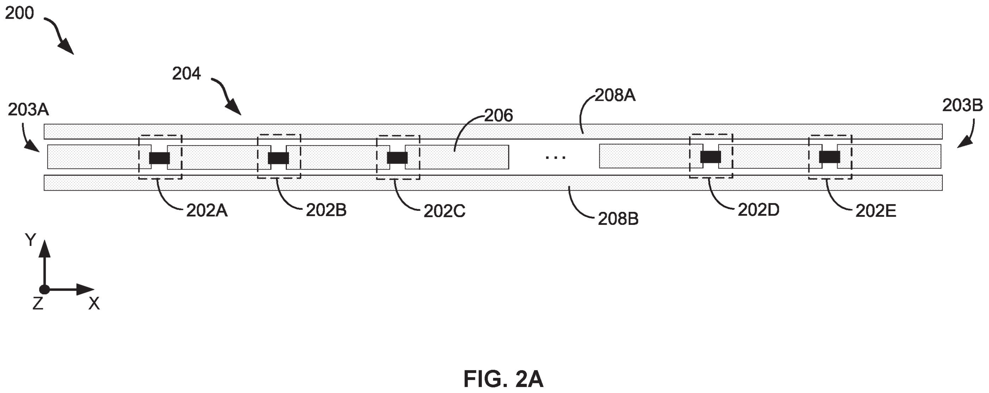

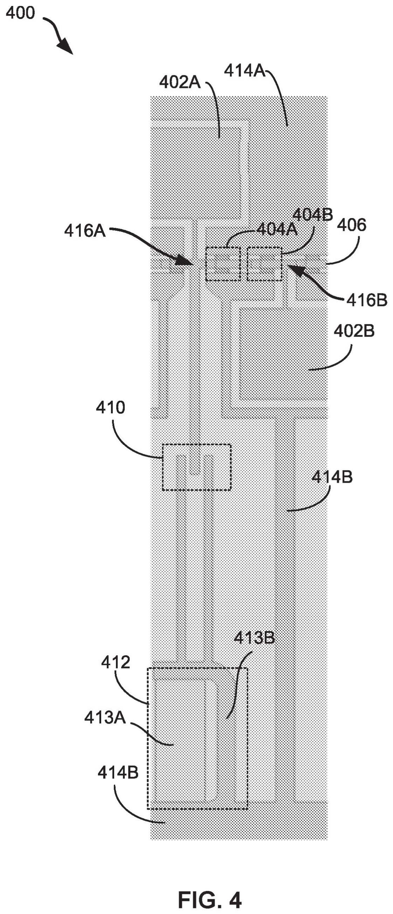

In some implementations, amplifiers in the signal hardware 104A may include a parametric amplifier. The parametric amplifier can be a traveling wave parametric amplifier (TWPA) fabricated on a surface of a substrate with Josephson junctions embedded in a transmission medium. In some instances, the transmission medium may include a coplanar waveguide, a microstrip waveguide, a slot line, a substrate integrated waveguide, or another type of planar transmission line. In some instances, the TWPA may include one or more of the Josephson junctions with a footprint over the surface of the substrate with two superconducting electrodes oriented along the central conductive strip of the coplanar waveguide. The footprint has a tapered shape (e.g., a triangular shape or another tapered shape) defined by two tapered edges and a base. In some instances, the TWPA may be implemented as the example TWPA 200, 400 shown in FIGS. 2A-2C and 4 or in another manner.

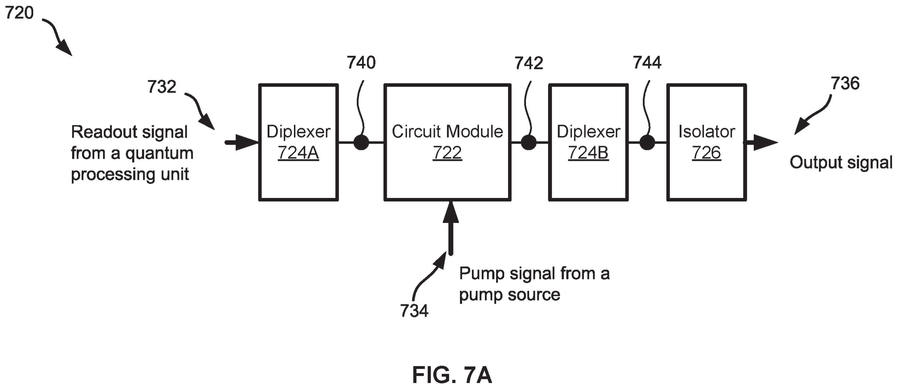

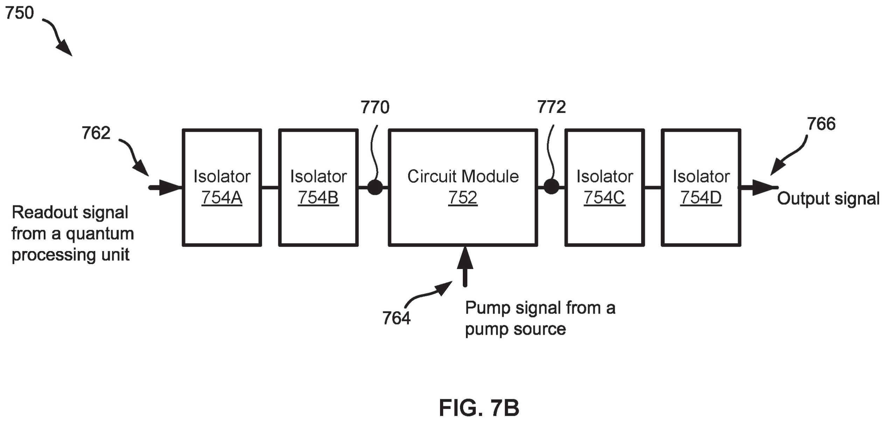

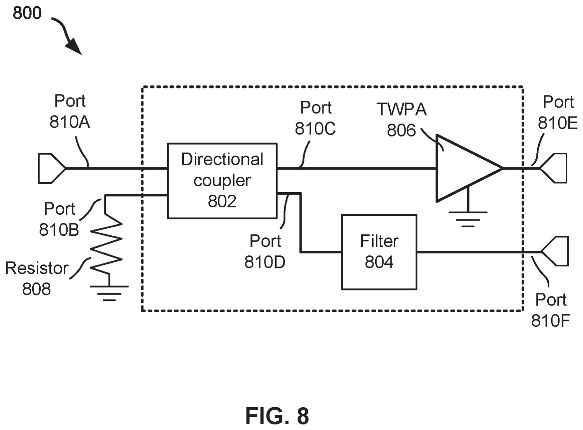

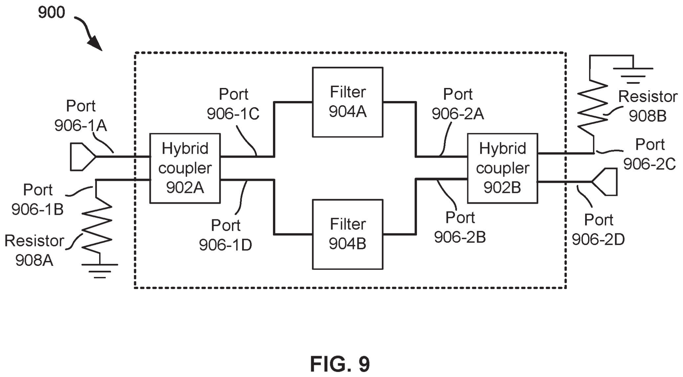

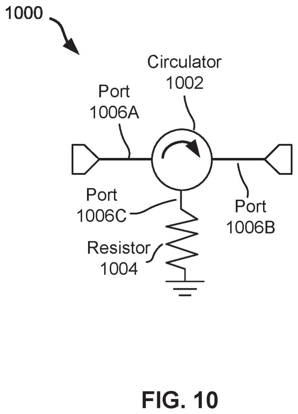

In some implementations, the signal delivery hardware of the signal hardware 104A may include a microwave payload circuit. The microwave payload circuit may be implemented as the example circuits 720 and 750 shown in FIGS. 7A, 7B or in another manner. In some instances, the microwave payload circuit includes a circuit module which can be implemented as the example circuit module 800 shown in FIG. 8, two diplexers which can be implemented as the example diplexer 900 shown in FIG. 9, and an isolator which can be implemented as the example isolator 1000 shown in FIG. 10. The microwave payload circuit may receive readout signals from qubits residing on the lowest-temperature thermal stage of a cryostat (e.g., the lowest-temperature thermal stage 408 of the cryostat 400 shown in FIG. 4) and output amplified readout signals to signal processing units residing on a thermal stage operating at a higher temperature.

The example controllers 106A communicate with the signal hardware 104A to control operation of the quantum computing system 103A. The controllers 106A may include classical computing hardware that directly interface with components of the signal hardware 104A. The example controllers 106A may include classical processors, memory, clocks, digital circuitry, analog circuitry, and other types of systems or subsystems. The classical processors may include one or more single- or multi-core microprocessors, digital electronic controllers, special purpose logic circuitry, e.g., an FPGA (field programmable gate array) or an ASIC (application specific integrated circuit), or other types of data processing apparatus. The memory may include any type of volatile or non-volatile memory or another type of computer storage medium. The controllers 106A may also include one or more communication interfaces that allow the controllers 106A to communicate via the local network 109 and possibly other channels. The controllers 106A may include additional or different features and components.

In some implementations, the controllers 106A include memory or other components that store quantum state information, for example, based on qubit readout operations performed by the quantum computing system 103A. For instance, the states of one or more qubits in the quantum processing unit 102A can be measured by qubit readout operations, and the measured state information can be stored in a cache or other type of memory system in one or more of the controllers 106A. In some cases, the measured state information is subsequently used in the execution of a quantum program, a quantum error correction procedure, a quantum processing unit (QPU) calibration or testing procedure, or another type of quantum process.

In some implementations, the controllers 106A include memory or other components that store a quantum program containing quantum machine instructions for execution by the quantum computing system 103A. In some instances, the controllers 106A can interpret the quantum machine instructions and perform hardware-specific control operations according to the quantum machine instructions. For example, the controllers 106A may cause the signal hardware 104A to generate control signals that are delivered to the quantum processing unit 102A to execute the quantum machine instructions.

In some instances, the controllers 106A extract qubit state information from qubit readout signals, for example, to identify the quantum states of qubits in the quantum processing unit 102A or for other purposes. For example, the controllers may receive the qubit readout signals (e.g., in the form of analog waveforms) from the signal hardware 104A, digitize the qubit readout signals, and extract qubit state information from the digitized signals. In some cases, the controllers 106A compute measurement statistics based on qubit state information from multiple shots of a quantum program. For example, each shot may produce a bitstring representing qubit state measurements for a single execution of the quantum program, and a collection of bitstrings from multiple shots may be analyzed to compute quantum state probabilities.

In some implementations, the controllers 106A include one or more clocks that control the timing of operations. For example, operations performed by the controllers 106A may be scheduled for execution over a series of clock cycles, and clock signals from one or more clocks can be used to control the relative timing of each operation or groups of operations. In some implementations, the controllers 106A may include classical computer resources that perform some or all of the operations of the servers 108 described above. For example, the controllers 106A may operate a compiler to generate binary programs (e.g., full or partial binary programs) from source code; the controllers 106A may include an optimizer that performs classical computational tasks of a hybrid classical/quantum program; the controllers 106A may update binary programs (e.g., at runtime) to include new parameters based on an output of the optimizer, etc.

The other quantum computer system 103B and its components (e.g., the quantum processing unit 102B, the signal hardware 104B, and controllers 106B) can be implemented as described above with respect to the quantum computer system 103A; in some cases, the quantum computer system 103B and its components may be implemented or may operate in another manner.

In some implementations, the quantum computer systems 103A, 103B are disparate systems that provide distinct modalities of quantum computation. For example, the computer system 101 may include both an adiabatic quantum computer system and a gate-based quantum computer system. As another example, the computer system 101 may include a superconducting circuit-based quantum computer system and an ion trap-based quantum computer system. In such cases, the computer system 101 may utilize each quantum computing system according to the type of quantum program that is being executed, according to availability or capacity, or based on other considerations.

FIG. 2A is a schematic diagram showing aspects of an example traveling wave parametric amplifier (TWPA) 200. As shown in FIG. 2A, the example TWPA 200 includes a series of unit cells 202, e.g., 202A, 202B, 202C, 202D, and 202E embedded in a transmission medium 204. The transmission medium 204 in the example TWPA 200 is a coplanar waveguide (CPW), which includes a central conductive strip206 and two ground planes 208A, 208B. The central conductive strip 206 is segmented into multiple sections, which are connected by the series of unit cells 202. In some implementations, the transmission medium 204 may be a microstrip waveguide, a slot line, a substrate integrated waveguide, or another type of planar transmission line. In some implementations, each unit cell 202 in the example TWPA 200 includes one or more Josephson junctions, one or more resonators, one or more capacitors, one or more inductors, or another circuit component. For example, the unit cell of the TWPA 200 may include a resonator, e.g., the resonator 412 capacitively coupled to the transmission medium 406 via a capacitor 410 as shown in FIG. 4.

In some implementations, the transmission medium 204 with the series of unit cells 202 may have a nonlinear frequency-dependent impedance which can be used to mediate energy exchange between signals. In some aspects of operation, the example TWPA 200 performs parametric amplification of a weak microwave signal (e.g., a readout signal from a qubit in the quantum processing unit 102) using a pump signal when both are input at an input port 203A and copropagating along the TWPA 200. An amplified microwave signal can be provided at an output port 203B.

In some implementations, each of the Josephson junctions along the example TWPA 200 may have an identical design. In some implementations, the Josephson junctions along the transmission medium 204 may have a periodically varying design. For example, sizes of the Josephson junctions can vary periodically along the transmission medium 204 to produce a band gap or to perform another function. In some instances, the Josephson junctions along the example TWPA 200 may be individually optimized and may have distinct characteristics, e.g., junction inductance values or another parameter. In some implementations, the example TWPA 200 is part of signal hardware, e.g., the signal hardware 104 of the control system 105 in the quantum computing system 103 as shown in FIG. 1. In some implementations, the example TWPA 200 may include additional and different features or components and components of the example TWPA 200 may be implemented in another manner. For example, the example TWPA 200 may include one or more pairs of probe pads (e.g., probe pads 402A, 402B) for characterizing one or more unit cells 202.

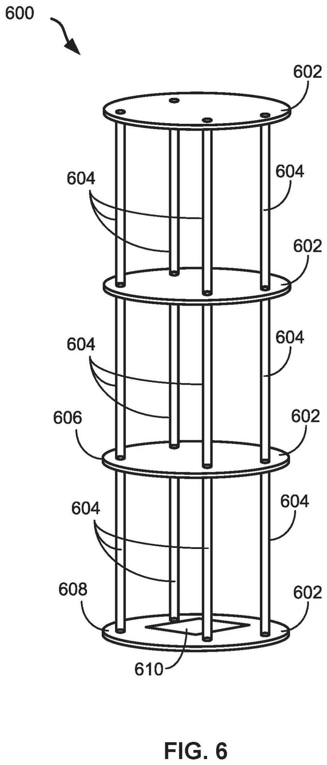

In some implementations, the example TWPA 200 may be mounted in a dilution refrigerator at the lowest-temperature thermal stage of a cryostat, e.g., at a temperature of 20 milli Kelvin (mK), and may operate at the same temperature as the quantum processing unit, e.g., the lowest-temperature thermal stage 608 of the cryostat 600 shown in FIG. 6. In some instances, during operation, a strong modulation tone (e.g., a pump signal) can be driven through the example TWPA 200 along with the readout signal to be amplified. In some implementations, the example TWPA 200 may be used in a microwave payload circuit, a microwave kinetic inductance detector (MKID) (e.g., for astronomy applications), or in another cryogenic microwave system. In some implementations, the methods and the systems presented here can improve a Josephson junction yield and provide accurate resistance targeting, which can result in improved properties, such as impedance matching, amplifier gain, saturation power, and bandwidth.

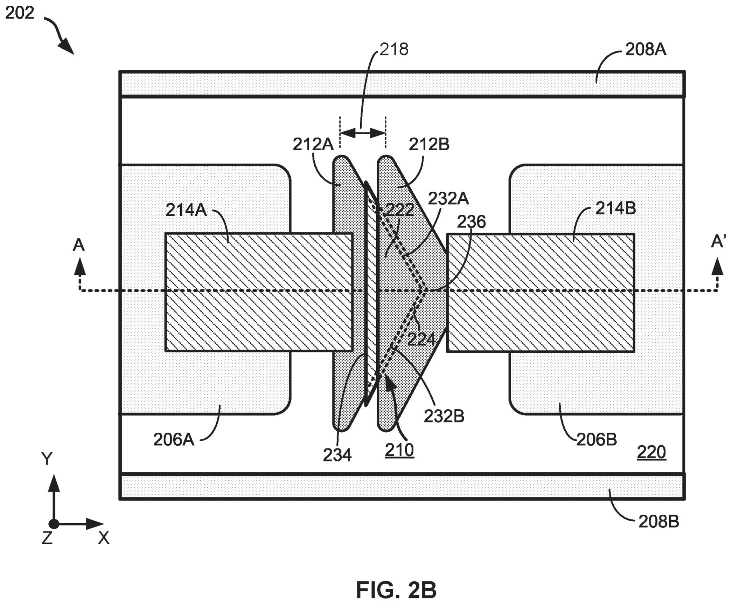

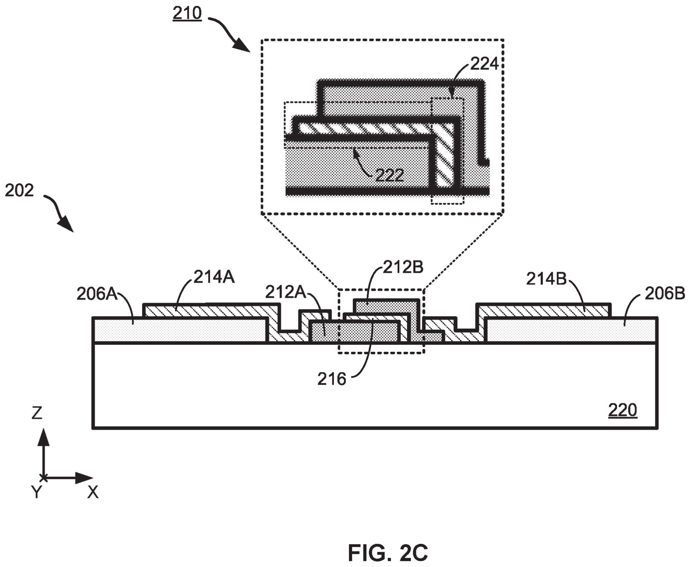

FIGS. 2B and 2C are schematic diagrams showing aspects of top and cross-sectional views of an example unit cell 202 in the traveling wave parametric amplifier (TWPA) 200 shown in FIG. 2A. As shown in FIGS. 2B and 2C, the example unit cell 202 of the TWPA 200 includes a Josephson junction 210. In some implementations, the example unit cell 202 may include multiple Josephson junctions or another circuit component, for example, a resonator, a capacitor, or an inductor. As shown in FIGS. 2B-2C, the example TWPA 200 resides on a substrate 220.

In certain instances, the substrate 220 may be an elemental semiconductor, for example silicon (Si), germanium (Ge), selenium (Se), tellurium (Te) or another elemental semiconductor. In some instances, the substrate 220 may also include a compound semiconductor such as aluminum oxide (sapphire), silicon carbide (SiC), gallium arsenic (GaAs), indium arsenide (InAs), and indium phosphide (InP). In certain instances, the substrate 220 may include a compound semiconductor such as silicon germanium (SiGe), silicon germanium carbide (SiGeC), gallium arsenic phosphide (GaAsP), and gallium indium phosphide (GaInP). In some instances, the substrate 220 may also include a superlattice with elemental or compound semiconductor layers. In one embodiment, the substrate 220 includes an epitaxial layer. In some examples, the substrate 220 may have an epitaxial layer overlying a bulk semiconductor or may include a semiconductor-on-insulator (SOI) structure.

As shown in FIGS. 2B and 2C, the Josephson junction 210 is formed between two superconducting electrodes, e.g., a superconducting bottom electrode 212A and a superconducting top electrode 212B, which are separated by a barrier 216. The two superconducting electrodes 212A, 212B are partially overlapping in the XY plane. The overlapping area has a footprint over the surface of the substrate in the XY plane. In the example TWPA 200 shown in FIG. 2B, the overlapping region of the two superconducting electrodes 212A, 212B has a triangular "arrowhead" shape in the XY plane, oriented along the extension direction of the central conductive strip segments 206A, 206B (e.g., along the X-axis). In some instances, the two superconducting electrodes 212A, 212B may have another distinct shape or may be arranged along another orientation. As shown in the example unit cell 202, the two superconducting electrodes 212A, 212B in a Josephson junction 210 reside on the substrate 220 between two central conductive strip segments 206A, 206B and between the two ground planes 208A, 208B, which are coupled together to the same potential.

In some implementations, each of the two superconducting electrodes 212A, 212B and the central conductive strip 206 may include a superconducting metal, such as aluminum (Al), niobium (Nb), tantalum (Ta), vanadium (V), tungsten (W), zirconium (Zr), or another superconducting metal. In some implementations, each of the two superconducting electrodes 212A, 212B may include a superconducting metal alloy, such as molybdenum-rhenium (Mo/Re), niobium-tin (Nb/Sn), or another superconducting metal alloy. In some implementations, each of the two superconducting electrodes 212A, 212B may include a superconducting compound material, including superconducting metal nitrides and superconducting metal oxides, such as titanium-nitride (TiN), niobium-nitride

(NbN), zirconium-nitride (ZrN), hafnium-nitride (HfN), vanadium-nitride (VN), tantalum-nitride (TaN), molybdenum-nitride (MoN), yttrium barium copper oxide (Y-Ba-Cu-O), or another superconducting compound material. In some instances, the two superconducting electrodes 212A, 212B may include multilayer superconductor-insulator heterostructures.

In some implementations, the two superconducting electrodes 212A, 212B are fabricated on a top surface of the substrate 220 and patterned using a microfabrication process or in another manner. For example, the two superconducting electrodes 212A, 212B may be formed by performing at least some of the following fabrication steps: using chemical vapor deposition (CVD), physical vapor deposition (PVD), atomic layer deposition (ALD), spin-on coating, and/or other suitable techniques to deposit respective superconducting layers on the substrate 220; and performing one or more patterning processes (e.g., a lithography process, a dry/wet etching process, a soft/hard baking process, a cleaning process, etc.) to form openings in the respective superconducting layers. In some instances, the two superconducting electrodes 212A, 212B are formed using a single shadow mask followed by an angled deposition. For example, a shadow mask can be formed using a Controlled Undercut Technique (CUT) to create a controlled amount of undercut on either side of the Josephson junction. In some examples, a shadow mask can be also created using a Niemeyer-Dolan technique, during which a free-standing resist bridge is created in the middle of the Josephson junction. A shadow mask from a CUT or a Niemeyer-Dolan technique can be created using an MMA/PMMA resist bilayer or another type of multi-layer resist structure. In some cases, the angled deposition may be a double-angled metal deposition, a shadow evaporation technique, or another type of angled deposition process. In some instances, the two superconducting electrodes 212A, 212B may be formed using another type of fabrication process. For example, the two superconducting electrodes 212A, 212B may be formed using separate lithography/deposition processes (e.g., two distinct patterned resist masks). For another example, the two superconducting electrodes 212A, 212B may be formed using a subtractive method (e.g., metal etching).

In the example unit cell 202, the two superconducting electrodes 212A, 212B are offset along the X axis by a distance 218. As shown in FIGS. 2B-2C, the barrier 216 includes two portions, e.g., a first portion 222 extending along the horizontal direction (e.g., in the XY plane) and a second portion 224 extending along the vertical direction (e.g., perpendicular to the XY plane). As shown in FIG. 2B, the first portion 222 of the barrier 216 resides on the top surface of the superconducting bottom electrode 212A over the surface of the substrate. The first portion 222 of the barrier 216 has a first footprint along the XY plane. In some implementations, the first footprint has a tapered shape where the width of the shape reduces toward one end. In some implementations, tapered edges 232A/232B of the tapered shape (first and second boundary sides of the first portion 222 of the barrier 216) are defined by the shape of edges of the superconducting bottom electrode 212A. For example, the tapered edges 232A/232B of the tapered shape may be straight (e.g., triangular shape), curved (e.g., concave, convex or both), stepped, pixelated, irregular, or in another shape; and the apex of the tapered shape may be sharp, rounded, flat or truncated. The second portion 224 of the barrier 216 resides on the surface of the substrate has a second footprint along the XY plane. As shown in FIG. 2C, the two superconducting electrodes 212A, 212B and the barrier 216 at the second portion 224 reside in contact with the substrate 220. In some implementations, the second footprint has a tapered arrow shape, a V-shape, or a chevron shape. As such, the base 234 of the tapered shape (third boundary side of the first portion 222 of the barrier 216) overlaps with the superconducting bottom electrode 212A in its central region along the Z axis, and the apex 236 of the first footprint of the barrier 216 overlaps with the superconducting top electrode 212B in its central region along the Z axis. Such configuration shown in FIG. 2B only allows the base 234 of the tapered shape of barrier 216 to be exposed to ambient environment and reduces contamination and uncontrolled oxidation to the portion of the barrier 216 which is sandwiched between the two superconducting electrodes 212A, 212B, and thus, improves the stability of the Josephson junctions 210 and the TWPA 200.

In some implementations, the barrier 216 may include a thin layer of an insulating material, a non-superconducting metal, or another material. When the barrier 216 includes an insulating material, the barrier 216 may have a thickness less than 3 nanometers (nm) in some cases. When the barrier 216 includes a non-superconducting metal, the barrier 216 may have a thickness in a range of a few hundred nanometers to micrometers. In some implementations, the barrier 216 may be fabricated using thermal oxidation, atomic layer deposition, or another fabrication technique. For example, the barrier 216 may be fabricated according to the operation 306 in the example process 300 or in another manner.

As shown in the example TWPA 200, the superconducting electrodes 212A, 212B of the Josephson junction 210 are electrically coupled to respective central conductive strip segments 206A, 206B via two respective superconductive patches ("bandaid") 214A, 214B. The respective superconductive patches 214A, 214B can enable electrical connection between the superconducting electrodes 212A, 212B and the respective central conductive strip segments 206A, 206B. In some implementations, the superconductive patches 214A, 214B contain the same superconductive material as the superconducting electrodes 212A, 212B, the central conductive strip 206, or another superconducting material. Such configuration shown in FIGS. 2A-2C using a method described above does not require extra leads to be formed to contact the respective superconducting electrodes of a Josephson junction and thus allows a simplified fabrication process.

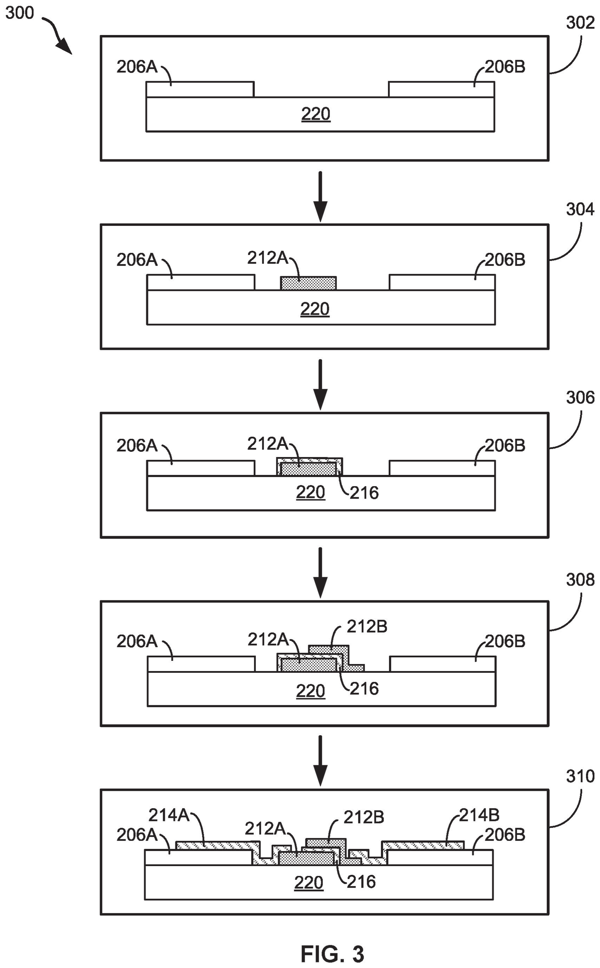

FIG. 3 is a flow chart 300 showing aspects of an example fabrication process 300. In some implementations, the example process 300 may be used for fabricating superconducting circuits in a quantum computing system. In some implementations, the example process 300 presented here is compatible with the fabrication process of superconducting qubits in a quantum processing unit and can allow a high yield at the wafer scale. In some instances, the example process 300 may be used to fabricate a traveling wave parametric amplifier (TWPA) with multiple Josephson junctions in a coplanar waveguide, e.g., the example TWPA 200 shown in FIGS. 2A-2C, and the example TWPA 400 with probe pads shown in FIG. 4. The example process 300 is performed on a crystalline silicon substrate or another type of substrate. The example process 300 may include additional or different operations, including operations to fabricate additional or different components, and the operations may be performed in the order shown or in another order. In some cases, operations in the example process 300 can be combined, iterated or otherwise repeated, or performed in another manner.

At 302, a coplanar waveguide is formed. In some implementations, the coplanar waveguide including a segmented central conductive strip (e.g., the central conductive strip segments 206A, 206B) and two ground planes (e.g., the ground planes 208A, 208B - see FIG. 2B) are formed on a substrate (e.g., the substrate 220). In some instances, the two ground planes are coupled to the same electric potential. The segmented central conductive strip of a coplanar waveguide contains a superconducting material such as a superconducting metal, a superconducting metal alloy, or a superconducting metal compound. For example, the coplanar waveguide may include aluminum (Al), niobium (Nb), or molybdenum-rhenium (Mo-Re). In some instances, the thickness of the central conductive strip is in a range of 100 nanometers (nm) and 1000 nm, or in another range. In some instances, the segmented central conductive strip of a coplanar waveguide may be formed on the substrate by performing at least some of the following microfabrication processing steps: performing one or more of the depositing processes (e.g., chemical vapor deposition (CVD), physical vapor deposition (PVD), atomic layer deposition (ALD), molecular beam epitaxy (MBE), etc.); and performing one or more patterning processes (e.g., a lithography process, a dry/wet etching process, a soft/hard baking process, a resist removing process, a cleaning process, etc.).

In some implementations, the substrate is a float-zone undoped silicon wafer with a high-resistivity or another type of substrate. In some instances, the top surface of the substrate prior to the formation of the coplanar waveguide may be cleaned to remove the native oxide at a metal/substrate interface between the substrate and the coplanar waveguide in order to reduce dielectric loss. For example, the substrate can be etched using a HF etching process and rinsed in DI water. In some instances, cleaning of the top surface of the substrate is performed to remove contaminants including organic contaminants and another type of contaminants. In some implementations, the substrate after cleaning may be loaded into deposition chamber to minimize reformation of the native oxide. In some implementations, another type of cleaning process may be used according to the type of substrate used.

At 304, a superconducting bottom electrode of a Josephson junction is formed. The superconducting bottom electrode (e.g., the superconducting bottom electrode 212A) can be patterned using an electron beam lithographical process on the top surface of the substrate and between two adjacent segments of the segmented central conductive strip segments. In some instances, the superconducting bottom electrode contains a superconducting material such as a superconducting metal, a superconducting metal alloy, or a superconducting metal compound. For example, the superconducting bottom electrode includes aluminum (Al), niobium (Nb), molybdenum-rhenium (Mo-Re), titanium-nitride (TiN), or niobium-nitride (NbN). In some instances, the thickness of the superconducting bottom electrode is in a range of 10 nm and 300 nm, or in another range. In some instances, the superconducting bottom electrode may be formed on the substrate by performing at least some of the following processing steps: performing one or more of the depositing processes (e.g., chemical vapor deposition (CVD), physical vapor deposition (PVD), atomic layer deposition (ALD), molecular beam epitaxy (MBE), etc.); and performing one or more patterning processes (e.g., a lithography process, a dry/wet etching process, a soft/hard baking process, a resist removing process, a cleaning process, etc.).

In some implementations, a shadow mask can be formed and used to form and pattern the superconducting bottom electrode. In some examples, the shape of the opening on the shadow mask determines the shape of the superconducting bottom electrode on the surface of the substrate. The opening on the shadow mask may have a tapered shape, for example a triangular shape or another tapered shape. In some instances, a shadow mask may be formed on the surface of the substrate using a photolithographic process, an electron beam lithographic process, or another lithographic process. In some instances, one or more resist layers may be used to form a shadow mask using a controlled undercut technique (CUT). For example, an electron-beam lithography may be performed using at least two electron-beam resist layers (e.g., a top imaging resist layer and a bottom undercut resist layer) to create the shadow mask, in which the bottom undercut resist layer is etched and removed creating a suspended, patterned top imaging resist layer. In some instances, processing conditions during the electron-beam lithography can be optimized to increase production yield by reducing resist residues at the metal/substrate interface and reducing aging of the Josephson junction. For example, soft bake temperatures of electron-beam resist layers can be optimized in order to increase dose contrast between the top imaging and bottom undercut resist layers to reduce electrical shorts and opens either via collapse of the top imaging resist layer, underexposure of the bottom undercut resist layer, or unintended leads due to overexposure of the bottom undercut resist layer. Additionally, resist development time can be optimized to further remove resist residue on the top surface of the substrate, which - in addition to potential reduction in aging - can also improve metal adhesion to the top surface of the substrate and improve chip yield. The development time can also be optimized to improve pattern fidelity and thus resistance targeting by yielding pattern features close to the intended size. In some instances, ethanol and oxygen plasma ashing, can also be used in the process after the development of the resist layers to assist the removal of resist residue, which can reduce aging of the Josephson junction. In some implementations, another type of shadow mask may be used, for example, a dielectric mask, a metal mask, or a metal alloy mask.

In some instances, after the formation of the shadow mask, the superconducting bottom electrode can be deposited using a first angled deposition process. In some instances, the first angled deposition process may use an angled physical vapor deposition (PVD), such as electron-beam evaporation, sputtering, epitaxial growth, or another type of deposition process. In certain examples, the formation of the superconducting bottom electrode using an angled PVD process through a shadow mask is performed at a first fixed angle (e.g., +*θ*). In some instances, prior to the first angled deposition of the superconducting bottom electrode, the surface of the substrate may be etched and cleaned to remove the native oxide layer as described in operation 302 or in another manner.

At 306, a barrier layer is formed on the superconducting bottom electrode. In some implementations, the barrier layer (e.g., the barrier layer 216) may be formed by oxidizing the superconducting bottom electrode. For example, an oxidation of the superconducting bottom electrode may be performed in air, oxygen, or another type of oxidizing environment, and at room temperature or at another elevated temperature. In certain instances, the barrier layer may have a thickness in a range of 0.5 nm and 10 nm. For example, when aluminum is used as the superconducting bottom electrode, the oxidation process allows a formation of a stable, repeatable aluminum oxide barrier layer on the surface of the superconducting bottom electrode.

The oxidation of the superconducting bottom electrode may be performed immediately after the formation of the superconducting bottom electrode in the same vacuum chamber. The oxidation process that forms the barrier layer (e.g., tunneling barrier) can also be optimized for more accurate resistance targeting. Improvements in quality of the barrier layer can also reduce/prevent resistance aging in the Josephson junction, for example by making the oxide more thermodynamically stable and resistant to further oxidation. In some instances, these improvements may be achieved by optimizing parameters, such as the temperature, pressure, or time, through the addition of a catalytic agent - such as ultraviolet light, or through another parameter of the oxidation process.

In some implementations, the barrier layer may be formed using another type of deposition method, for example, atomic layer deposition (ALD), molecular beam epitaxy (MBE) or chemical vapor deposition (CVD). In certain instances, the barrier layer is formed on exposed surfaces of the superconducting bottom electrode, including the top surface along the XY plane and sidewalls perpendicular to the XY plane.

In some cases, the formation process of the barrier layer may cause a formation of an oxide layer or a formation of the barrier layer on any exposed surfaces through the opening in the shadow mask. For example, the oxidation process may also cause an oxidation on the exposed surface of the substrate, the segmented central conductive strip of the coplanar waveguide, or another circuit component.

At 308, a superconducting top electrode is formed. In some implementations, the superconducting top electrode (e.g., the superconducting top electrode 212B) may be formed using the same shadow mask which is used for the formation of the superconducting bottom electrode using a second angled deposition process. In some instances, the second angled deposition process for the formation of the superconducting top electrode may be implemented as the first angled deposition process with respect to the operation 304. In certain examples, the second angle deposition for the formation of the superconducting top electrode 212B is performed at a second, distinct angle (e.g., -*θ*). The difference between the two angles and the thickness of the shadow mask, and directionality of the deposition technique used in the angled deposition process may determine the overlapping area between the two superconducting bottom and top electrodes. The operation 304 and 308 for the formation of the superconducting bottom and top electrodes 212A, 212B is known as a double-angled metal deposition method. In some instances, prior to the second angled deposition of the superconducting top electrode, the surface of the substrate may be etched and cleaned to remove the oxide layer that is formed during the formation of the barrier layer as described in operation 302 or in another manner.

In some implementations, the superconducting top electrode includes the same superconducting material as or a different superconducting material from the superconducting bottom electrode. In some implementations, the superconducting top electrode has a thickness in a range of 100 to 300 nm, or in another range. For example, the thickness of the superconducting top electrode may be increased to reduce self-shadowing effects from the superconducting bottom electrode and to improve the chip yield. The thicknesses of the superconducting bottom and top electrodes in the Josephson junction may be further optimized according to the design/layout of the TWPA.

At 310, superconductive patches are formed. In some implementations, the superconductive patches (e.g., the superconductive patches 214A, 214B) are formed to electrically connect the superconducting bottom and top electrodes of the Josephson junction to the two respective segments of the segmented central conductive strip (e.g., the segments 206A, 206B). Particularly, as shown in FIG. 3, a first superconductive patch 214A covers a portion of the top surface of the first segment 206A, a portion of the superconducting bottom electrode 212A, and a portion of the top surface of the substrate 220. Similarly, a second superconductive patch 214B covers a portion of the top surface of the second segment 206B, a portion of the superconducting top electrode 212B, and a portion of the top surface of the substrate 220. In some examples, the first and second superconductive patches 214A, 214B have dimensions that are large enough for making reliable electrical connection with the respective segments 206A, 206B and the respective superconducting electrodes 212A, 212B.

In some instances, the superconductive patches may be formed by performing at least some of the following processing steps: performing one or more of the depositing processes (e.g., chemical vapor deposition (CVD), physical vapor deposition (PVD), atomic layer deposition (ALD), molecular beam epitaxy (MBE), etc.); and performing one or more patterning processes (e.g., a lithography process, a dry/wet etching process, a soft/hard baking process, a resist removing process, a cleaning process, etc.). In some instances, the superconductive patches may have a thickness in a range of 100 to 1000 nm, or in another range.

Prior to the formation of the superconductive patches, the shadow mask used for the formation of the superconducting bottom and top electrodes can be removed. In some implementations, the top surfaces of the segmented central conductive strip and the superconducting bottom and top electrodes may also be cleaned prior to the formation of the superconductive patches. For example, a native oxide layer may form on the top surface of the two segments due to their exposure to atmosphere in between lithographic and deposition steps. For another example, the barrier layer may be formed on the entire top surface of the superconducting bottom electrode. In some instances, a portion of the native oxide and the barrier on the superconducting bottom electrode can be removed prior to the formation of the superconductive patches in order to form reliable ohmic contacts between superconductors, providing low DC-resistance and high-quality factor at microwave frequencies. In certain examples, the native oxide is removed to reduce dielectric losses at various interfaces. In some implementations, techniques and conditions for removing the native oxide layer and the barrier layer may be different according to the superconducting materials used, geometries of the superconducting electrodes (e.g., thickness), nature of the native oxide layer, and instruments that are available.

FIG. 4 is a schematic diagram showing aspects of an example traveling wave parametric amplifier (TWPA) 400. The example TWPA 400 fabricated on a surface of a substrate includes multiple Josephson junctions 404 (e.g., 404A, and 404B) connected in series along a central conductive strip 406 of a coplanar waveguide. The coplanar waveguide includes two ground planes 414A, 414B. In some implementations, the example TWPA 400 may include a number of Josephson junctions in a range of 100 to 1000, or in another range. As shown in FIG. 4, the example TWPA 400 also includes two probe pads 402, e.g., a first probe pad 402A and a second probe pad 402B. In some implementations, the example TWPA 400 may include additional and different features or components and components of the example TWPA 400 may be implemented in another manner.

In some implementations, the first and second probe pads 402A, 402B integrated in the TWPA 400 can be used to directly characterize circuit components (e.g., one or more Josephson junctions 404 along the transmission line 406) residing between the first and second probe pads 402A, 402B. In some implementations, the first and second probe pads 402 can be used to determine the yield of the Josephson junctions 404 by performing a measurement at room temperature, e.g., measuring DC resistance or microwave response of the two Josephson junctions 404A, 404B at room temperature. In some examples, the measured value of the room-temperature resistance of the Josephson junctions can be compared to a threshold value or a predetermined range to determine the yield and to facilitate a chip screening and selection process.

As shown in FIG. 4, the first and second probe pads 402A, 402B are galvanically coupled to the central conductive strip 406 of the coplanar waveguide and thus electrically floating without connecting to ground. Specifically, the first probe pad 402A is electrically coupled to the central conductive strip 406 at a first port 416A; and the second probe pad 402B is electrically coupled to the central conductive strip 406 at a second port 416B. The first and second probe pads 402A, 402B are used to characterize the two Josephson junctions 404A, 404B between the first and second ports 416A, 416B.

As shown in the example TWPA 400 in FIG. 4, a resonator 412 is capacitively coupled to the central conductive strip 406 of the coplanar waveguide via a capacitive coupler 410. The capacitive coupler 410 and the resonator 412 are coupled between the central conductive strip 406 and the ground plane 414B. In some instances, the resonator 412 that is capacitively coupled between the central conductive strip 406 and the ground plane 414B may be used for phase matching. As shown in FIG. 4, the resonator 412 is an LC resonator including a parallel-plate capacitor 413A and an inductor 413B, which are connected in parallel. In some instances, the parallel-plate capacitor 413A includes a first electrode electrically coupled to the central conductive strip of the coplanar waveguide (e.g. through a capacitive coupler), a second electrode electrically coupled to the ground plane, and a thin dielectric layer separating the first and second electrodes. In certain instances, the inductor 413B can be a conductive trace with a self-inducted inductance. The inductance value of the inductor 413B is defined by the geometric parameters of the conductive trace.

In some implementations, the first and second probe pads 402A, 402B are electrically floating at a certain potential without connecting to ground. The first and second probe pads 402A, 402B do not add any detrimental parasitic capacitance to the example TWPA 400. In some implementations, the first and second probe pads 402A, 402B can add extra shunt capacitance to the ground plane 414A, 414B and affect the total capacitance. In some implementations, such shunt capacitance between the probe pads 402 and the ground plane 414 can be tolerated. In some implementations, the shunt capacitance needs to be adjusted so that the total capacitance to the ground plane does not exceed a predetermined capacitance value so as to allow for impedance matching.

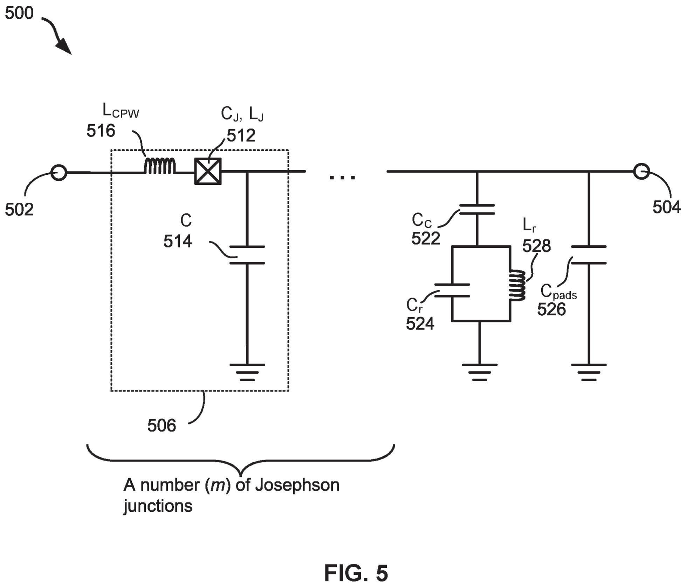

An equivalent circuit diagram of the example TWPA 400 with the two electrically floating probe pads 402A, 402B is shown in FIG. 5. In some implementations, design of the probe pads can be simulated using a linear electromagnetic (EM) simulator, such as HFSS, AWR, or in another manner. In some instances, the first and second probe pads 402A, 402B can be fabricated using an optical lithographical process during the formation of the coplanar waveguide, e.g., during the operation 302 of the example process 300, or in another manner. In certain instances, the first and second probe pads 402A, 402B can be probed using two-point or four-point probing configurations. In certain examples, dimensions and positions of the first and second probe pads 402A, 402B may be determined according to the availability of surfaces on the chip or another parameter.

FIG. 5 is a diagram showing an equivalent circuit 500 representing circuit components of a unit cell in an example traveling wave parametric amplifier (TWPA) with two probe pads. The unit cell between a first port 502 and a second port 504 includes one or more sections 506 with one or more (e.g., *m* ≥ 1) Josephson junctions 512 and segments of a transmission medium (e.g., coplanar waveguide) coupling the one or more Josephson junctions 512 in series. In some instances, multiple Josephson junctions 512 in a unit cell may provide a higher gain without reducing phase matching. In some instances, the number (m) of Josephson junctions 512 in a unit cell can be tuned for achieving desired device performances, e.g., m = 2, 4, or another value. In certain instances, multiple Josephson junctions 512 in a unit cell may be able to utilize the surface of a substrate more efficiently. When the unit cell includes two Josephson junctions 512 (e.g., m = 2) between the first and second ports 502, 504, the equivalent circuit 500 may represent the circuit components between the two probe pads 402A, 402B of the example TWPA 400 shown in FIG. 4.

Each of the one or more Josephson junctions 512 has an effective capacitance (*C_{J}*) which is defined by the area of the Josephson junction, which is the overlapping area of the two superconducting electrodes (e.g., the first and second portions of the Josephson junction 210 shown in FIGS. 2A and 2B), the thickness of a barrier layer (e.g., the barrier layer 216 between the two superconducting electrodes 212A, 212B), and the frequency-dependent dielectric constant. The Josephson junction 512 also has a characteristic Josephson inductance (*Lⱼ*). In some implementations, the one or more Josephson junctions 512 in the one or more sections 506 may have identical or distinctive parameters, e.g., effective capacitance or Josephson inductance.

The transmission medium (e.g., a coplanar waveguide) has a capacitance C 514 and a geometric inductance (*L_{CPW}*) 516. In some implementations, the capacitance C 514 is defined by a capacitance (*C_{CPW}*) and a hopover capacitance (*Cₕₒₚₒᵥₑᵣ*). In some instances, the capacitance (*C_{CPW}*) is the capacitance-to-ground of the coplanar waveguide, which is defined between the central conductive strip and the ground plane. The hopover capacitance (*Cₕₒₚₒᵥₑᵣ*) is the capacitance at an area between a "hopover" conductive line that shorts both sides of the ground plane (e.g., ground plane 208A, 208B) and the central conductive strip of the coplanar waveguide. The conductive line and the central conductive strip are separated by a patterned dielectric layer. In other words, the hopover capacitance (*Cₕₒₚₒᵥₑᵣ*) is a capacitance between the central conductive strip and the ground plane at the area where the hopover conductive line crosses the central conductive strip of the coplanar waveguide. In some implementations, the capacitance C 514 can be expressed as C = *C_{CPW} + Cₕₒₚₒᵥₑᵣ.* In some instances, the *Cₕₒₚₒᵥₑᵣ* can be adjusted to account for the extra parasitic capacitance caused by the probe pads 402A, 402B.

The equivalent circuit 500 further includes a first capacitor 522, a second capacitor 524, a third capacitor 526, and an inductor 528. As shown in FIG. 5, the first capacitor 522 having a capacitance of *C_{c}* is associated with the capacitive coupler 410 shown in FIG. 4. The second capacitor 524 with a capacitance of *Cᵣ* corresponding to the parallel-plate capacitor 413A and the inductor 528 with an inductance of *Lᵣ* corresponding to the inductor 413B together represent the resonator 412 shown in FIG. 4. The third capacitor 526 having a capacitance of *C_{pads}* is associated with the capacitance between each of the two probe pads 402A, 402B and the ground plane in the example TWPA 400.

FIG. 6 is a block diagram showing aspects of an example cryostat 600 in a quantum computing system. As shown in FIG. 6, the example cryostat 600 may include one or more thermal stages 602. In some implementations, the example cryostat 600 may be used to expose devices and samples to environments of very low temperature (e.g., T < 120 K). In some implementations, such environments are thermally isolated through insulating walls and are evacuated, typically having a pressure in the range of 10⁻³ mbar to 10⁻⁹ mbar, thereby allowing the example cryostat 600 to operate at stable temperatures without appreciable thermal losses.

In some implementations, the one or more thermal stages 602 may correspond to radiation shields, thermalization plates, or both. In some instances, a thermal stage 602 in the example cryostat 600 may be formed of a material having a high thermal conductivity at cryogenic temperatures, such as below 120 K. For example, a thermal stage 602 may be formed of a material having a thermal conductivity of at least 1 W/(m·K) as measured at 4 K. In some examples, a high thermal conductivity allows the thermal stage 602 to mitigate the development of temperature gradients, thereby maintaining a substantially uniform temperature across their respective masses. In some implementations, such material in a thermal stage 602 may include oxygen-free high conductivity copper and its alloys, including a C101 copper alloy or a beryllium-copper alloy (e.g., Cu with 0.5 - 3% Be) or another type of alloy.).

In some implementations, the example cryostat 600 may include any number of thermal stages 602 to support subsystems, devices, and samples for cryogenic refrigeration. As a result, the example cryostat 600 may position the thermal stages 602 to define a spatial sequence of thermal stages, such as in a linear sequence or an angular sequence. FIG. 6 depicts four thermal stages 602 in an equally spaced linear sequence. In some implementations, the example cryostat 600 may include any number and spacing of thermal stages 602 as needed. In the example shown in FIG. 6, the example cryostat 600 includes one or more structural supports 604 to position the thermal stages 602 into the spatial sequence of thermal stages. In some examples, the structural supports 604 may be formed of a material having a low thermal conductivity at cryogenic temperatures, e.g., less than 0.5 W/(m·K) at or below 50 K, such as a stainless-steel alloy or a glass-epoxy laminate of G10 grade. In this case, the structural supports 604 thus additionally impede a flow of heat between the thermal stages 602. As such, the example cryostat 600 may include one or more thermal stages dedicated to a specific temperature during operation. For example, the example cryostat 600 may be configured such that each thermal stage operates at a progressively decreasing temperature as a depth of the cryostat increases.

In some implementations, the example cryostat 600 includes one or more refrigeration systems (not shown) thermally coupled to each of the thermal stages 602. For example, the example cryostat 600 may include a pulse-tube refrigeration system coupled to a second lowest-temperature thermal stage 606 and a 3He/4He dilution refrigeration system thermally coupled to a lowest-temperature thermal stage 608. The refrigeration systems establish specific operating temperatures for the thermal stages to which they are respectively thermally coupled. In some implementations, the refrigeration systems may define a distribution of operating temperatures along the spatial sequence of thermal stages. In some implementations, a pulse-tube refrigeration unit may be configured to optimally extract heat at temperatures to about 4 K and a 3He/4He dilution refrigeration unit may be configured to optimally extract heat at temperatures below 1 K.

In the example shown in FIG. 6, a microwave payload circuit 610 is configured on the lowest-temperature thermal stage 608 of the example cryostat 600. In some implementations, the microwave payload circuit 610 may be implemented as the example microwave payload circuits 720, 750 shown in FIGS. 7A and 7B. In some implementations, the microwave payload circuit 610 is configured on the same stage with one or more quantum processing units (not shown). In some implementations, the microwave payload circuit 610 receives a pump signal from a pump source. In some implementations, the pump source may be configured outside of the insulating walls of the cryostat 400 at a warmer temperature, e.g., room temperature. In some instances, the pump source may be configured at a higher-temperature thermal stage. In some instances, the microwave payload circuit 610 outputs an output signal to a high electron mobility transistor (HEMT) which can be located at a second lowest-temperature thermal stage 606. In some implementations, the pump source may be coupled to the microwave payload circuit 610 through a pump line.

FIG. 7A is a block diagram showing aspects of an example microwave payload circuit 720. The example microwave payload circuit 720 is passive microwave circuitry used between a quantum processing unit located on the lowest-temperature thermal stage and a high electron mobility transistor (HEMT) located on a higher-temperature thermal stage (e.g., 4 K) in a cryostat. As shown in FIG. 7A, the example microwave payload circuit 720 includes a first diplexer 724A, a circuit module 722, a second diplexer 724B, and an isolator 726. The circuit module 722 is coupled to the first diplexer 724A at a first node 740 and coupled to the second diplexer 724B at a second node 742. The second diplexer 724B is coupled to the isolator 726 at a third node 744. In some implementations, the circuit module 722 may include a directional coupler, a parametric amplifier, and one or more filters. In some instances, the circuit module 724 may include another circuit component. The example microwave payload circuit 720 may be a part of signal hardware of a control system. For example, the example microwave payload circuit 720 is part of the signal hardware 104 of the control system 105 as shown in FIG. 1. As shown in FIG. 7A, the example microwave payload circuit 720 includes an input port 732 for receiving a readout signal from the quantum processing unit and a pump port 734 for receiving a pump signal from a pump source, and one output port 736 for providing an output signal, for example to the HEMT. In some instances, the output signal may include an amplified readout signal or another type of signal. The example microwave payload circuit 720 can reduce the number of circulators or isolators that are typically needed. In some implementations, the example microwave payload circuit 720 may include additional and different features or components and components of the example microwave payload circuit 720 may be implemented in another manner.

In some implementations, the first diplexer 724A shields the quantum processing unit from a parametric amplifier in the circuit module 722. In some instances, the first diplexer 724A, the circuit module 722, and the second diplexer 724B are planar devices, which may be manufactured on the same semiconductor substrate to form an integrated module. In some implementations, planar microwave circuit components in the first diplexer 724A, the circuit module 722, and the second diplexer 724B are formed on separate substrates, separate dies, or printed circuit boards (PCBs), and are bonded (e.g., wire-bonded) to a substrate, e.g., the substrate with the TWPA of the circuit module 722, to form a single module. In some implementations, the example microwave payload circuit 720 is a Monolithic Microwave Integrated Circuit (MMIC) module, where a majority of the circuit components may be optimized and formed on the same substrate with the TWPA. In certain examples, the example microwave payload circuits 720 in FIG. 7A are in the form of a single module. In some instances, planar microwave circuit components in the first diplexer 724A, the circuit module 722, and the second diplexer 724B can be implemented as a high-dielectric constant ceramic circuit for further miniaturization. In certain instances, discrete circuit components including a circulator in the isolator 726 (e.g., the circulator 1002 of the isolator 1000) are implemented as surface mount components.

In some instances, each of the first and second diplexer 724A, 724B are implemented as the example diplexer 900 shown in FIG. 9. In some implementations, the circuit module 722 is implemented as the example circuit module 800 shown in FIG. 8. The isolator 726 may be implemented as the isolator 1000 shown in FIG. 10 or in another manner. In some implementations, the parametric amplifier in the circuit module 722 is implemented as the TWPAs 200, 400 shown in FIGS. 2A-2C, and 4, or the circuit module 722 may be implemented in another manner. In some implementations, the circuit components in the first diplexer 724A, the circuit module 722, and the second diplexer 724B include superconducting materials including superconducting metals, superconducting metal alloys, superconducting compound materials, and another type of superconducting material. In some instances, the isolator 726 may be a cryogenic isolator.

During operation, a readout signal from a quantum device of a quantum processing unit is received by the first diplexer 724A at the input port 732. When a first frequency of the readout signal is within the frequency band of the first diplexer 724A, the readout signal is then passed by the first diplexer 724A to the first node 740 and received by the circuit module 722. A pump signal is received at the pump port 734 of the circuit module 722. An amplified readout signal is produced and output to the second diplexer 724B at the second node 742. When a second frequency of the amplified signal is within the frequency band of the second diplexer 724B, the amplified readout signal is then passed by the second diplexer 724B to the isolator 726 at the third node and further output to the output port 736. When a leaked pump signal from the circuit module 722 is received by the first diplexer 724A at the first node 740 and when a third frequency of the leaked pump signal is out of the frequency range of the first diplexer 724A, the leaked pump signal is blocked by the first diplexer 724A from reaching to the quantum processing unit. When a noise signal is received at the output port 736, for example a thermal noise, the noise signal can be blocked by the isolator 726 from reaching the second diplexer 724B, the circuit module 722, the first diplexer 724A, and eventually to the quantum processing unit.

FIG. 7B is a block diagram showing aspects of an example microwave payload circuit 750. The example microwave payload circuit 750 is passive microwave circuitry used between a quantum processing unit located at the lowest-temperature thermal stage and a high electron mobility transistor (HEMT) located on a higher-temperature thermal stage (e.g., 4 K) in a cryostat (e.g., the second lowest-temperature thermal stage 606 in the example cryostat 600 shown in FIG. 6). As shown in FIG. 7B, the example microwave payload circuit 750 includes a circuit module 752 and four isolators including a first isolator 754A, a second isolator 754B, a third isolator 754C and a fourth isolator 754D. In some implementations, the example microwave payload circuit 750 may be part of signal hardware of a control system. For example, the example microwave payload circuit 750 is part of the signal hardware 104 of the control system 105 as shown in FIG. 1. In some implementations, the example microwave payload circuit 750 may include additional and different features or components and components of the example microwave payload circuit 750 may be implemented in another manner.

As shown in FIG. 7B, the isolators 754 are grouped into two pairs. For example, as shown in FIG. 7B, a first pair including the first and second isolators 754A, 754B and a second pair including the third and fourth isolators 754C, 754D are separated by the circuit module 752. The first and second isolators 754A, 754B are coupled in series; and the third and fourth isolators 754C and 754D are coupled in series. The circuit module 752 is coupled to the first pair at the first node 770 and coupled to the second pair at the second node 772. In some implementations, the four isolators 754A, 754B, 754C, and 754D are identical and each of the four isolators 754A, 754B, 754C, and 754D includes a single-junction isolator. In some instances, each of the four isolators 754A, 754B, 754C, and 754D is implemented as the isolator 726 in the example microwave payload circuit 720 in FIG. 7A or in another manner. In some implementations, the circuit module 752 is implemented as the circuit module 722 in the example microwave payload circuit 720 in FIG. 7A or in another manner.

In some instances, the circuit module 752 may include planar devices, which can be manufactured on the same semiconductor substrate, manufactured separately, and integrated on a substrate, e.g., a PCB, or in another manner, to form an integrated module. In some implementations, the number of interfaces between the quantum processing unit, the parametric amplifier, and the mixing chamber plate (MXC) may be reduced. In some implementations, the systems presented here are simple to install in a dilution refrigerator.

In some cases, because some of this circuitry sits on the crucial path between the quantum integrated circuit and the TWPA, at least a portion of the circuit components of the microwave payload circuits 720, 750 include superconducting materials. For example, circuit traces of microwave components, e.g., the first diplexer, directional coupler, and the filter in the circuit module 722 can be fabricated by plating a superconducting metal (e.g., indium) on traces made of a normal conductive metal (e.g., copper) in a standard PCB, forming a dual-layer structure.

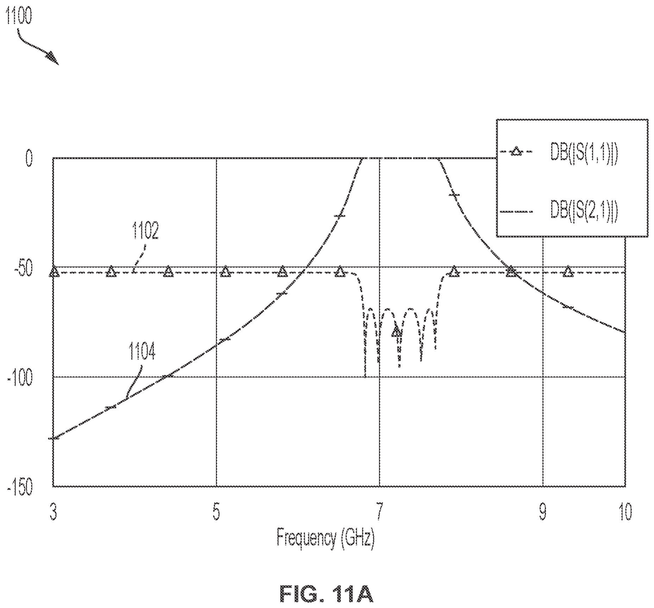

In some aspects of operation, a readout signal is received at an input port 762 of the first isolator 754A. In some instances, when the readout signal is "well matched", the input impedance is 50 ohm. In certain instances, when the readout signal is "well matched", the reflection loss (S11), for example as shown in FIGS. 11A-11B may be equal to or less than -10 dB. When the readout signal is well matched at the first and second isolators, the readout signal is passed by the first pair of isolators 754A, 754B to the circuit module 752 at the first node 770. The circuit module 752 receives a pump signal can be received at a pump port 764. The circuit module 752 produces an amplified readout signal at the second node 772, and the second pair of isolators 754C, 754D can pass the readout signal to an output port 766 when the amplified readout signal is well matched at the third and fourth isolators 754C, 754D. In some implementations, the first pair of isolators 754A, 754B can provide isolation to prevent the pump signal that is received by the circuit module 752 reflected off the parametric amplifier back towards the quantum processing unit. In some implementations, the first pair of isolators 754A, 754B provide a matched input impedance (e.g., a broadband 50-Ohm) for the parametric amplifier in a frequency band of the parametric amplifier (e.g., ~4-8 GHz). In certain instances, the first pair of isolators 754A, 754B also reduces gain ripples in the frequency band of the parametric amplifier, and provides extra isolation from 4 K noise. In some implementations, the second pair of isolators 754C, 754D is coupled between the parametric amplifier of the circuit module 752 and the MXC plate (and thus the HEMT at the 4 K stage). The second pair of isolators 754C, 754D can protect the parametric amplifier and the quantum processing unit from the 4-K noise. For example, see Sank, Daniel Thomas (2014). Fast, Accurate State Measurement in Superconducting Qubits [Doctoral Dissertation, University of California, Santa Barbara]. https://web.physics.ucsb.edu/~martinisgroup/theses/Sank2014.pdf. In some implementations, the second pair of isolators 754C, 754D provide a matched input impedance (e.g., a broadband 50-Ohm) for the parametric amplifier across the frequency band of the parametric amplifier.

FIG. 8 is a block diagram showing aspects of an example circuit module 800. The example circuit module 800 shown in FIG. 8 includes a directional coupler 802, a filter 804, and a traveling wave parametric amplifier (TWPA) 806. As shown in FIG. 8, the example circuit module 800 is a four-port device, including two input ports 810A and 810F, one output port 810E and one port 810B terminated to the ground via a resistor 808. In some implementations, the example circuit module 800 may be implemented as the circuit modules 722, 752 in the example microwave payload circuits 720, 750 shown in FIGS. 7A and 7B. Specifically, the port 810A can be coupled to an output of a diplexer (e.g., to the first diplexer 724A at the port 740 shown in FIG. 7A) for receiving a readout signal from a qubit of a quantum processing unit. The port 810E can output an amplified readout signal to another diplexer (e.g., to the second diplexer 724B at the port 742 shown in FIG. 7A). The port 810F may be coupled to a pump port (e.g., the pump port 734, 764 of FIGS. 7A, 7B) for receiving a pump signal from a pump source. In some implementations, the port 810A can be coupled to an output of an isolator (e.g., to the second isolator 754B at the first node 770 shown in FIG. 7B) for receiving the readout signal from a qubit of a quantum processing unit, and the port 810E can output the amplified readout signal to another isolator (e.g., to the third isolator 754C at the second node 772 shown in FIG. 7B). The directional coupler 802 is coupled to the TWPA 806 at a port 810C and to the filter 804 at a port 810D. In some implementations, the example circuit module 800 may include additional and different features or components and components of the example circuit module 800 may be implemented in another manner.

In some implementations, the directional coupler 802 allows the pump signal received at the port 810F to couple into the TWPA 806 with a minimal insertion loss to the readout signal being amplified. For example, in order to provide an appropriate balance between the insertion loss of the readout signal and a coupling of the pump signal to the TWPA 806, the directional coupler 802 can have a coupling of -20 dB. All three ports (e.g., ports 810A, 810C, and 810D shown in FIG. 8) of the directional coupler 802 have a matching of less than -15 dB across an operational frequency band of the TWPA 806. In some implementations, the directional coupler 802 may have a directivity of > 10 dB to prevent leaking of the pump signal from the port 810F across the directional coupler 802 back towards the quantum processing unit (e.g., from the port 810D to the port 810A). In some instances, the directional couplers 802 can be a discrete component or may be configured in another manner.

In some implementations, the TWPA 806 of the example circuit module 800 can be used as a first stage low-noise amplifier (LNA) to the readout signal from the qubit of the quantum processing unit. In some instances, the TWPA 806 is a broadband microwave parametric amplifier which can provide a gain of ~20 dB of to the readout signal. In some implementations, the operational frequency band of the TWPA 806 can be centered around the frequency of the pump signal. For example, the TWPA 806 has an operational frequency band in a range of 4-8 GHz covering the frequency range of the readout signals (e.g., 7-7.5 GHz), and is centered at a frequency of 6.2 GHz. In some implementations, the TWPA 806 may be implemented as the example TWPA 200, 400 shown in FIGS. 2A-2C, and 4 or in another manner.

In some implementations, the filter 804 of the example circuit module 800 can be a bandpass filter which can pass the pump signal with a frequency in a frequency range (e.g., -3 dB pass band of 6-6.7 GHz). As shown in FIG. 8, the pump signal received at the port 810F with a frequency of 6.2 GHz can pass through the filter 804 and can be fed to the TWPA 806 via the directional coupler 802.

In some implementations, a pump source is located at a higher-temperature thermal stage or outside the dilution refrigerator at room temperature. In some implementations, a pump line between the pump source and the example circuit module 800, may include attenuators at various thermal stages having attenuation losses. The attenuation in the pump line may be used to suppress the amount of thermal noise from higher-temperature thermal stages to the circuit module 800. For example, a total attenuation of ~30 dB (e.g., the nominal configuration is 10 dB at the 4 K stage, 10 dB at the 1 K stage, and 10 dB at the MXC) and a loss of 20 dB via coupling are present on the pump line. In certain instances, the pump line can be a source of undesired thermal noise from higher-temperature thermal stages, which can leak back to the quantum processing unit positioned at the lowest-temperature thermal stage. In the example microwave payload circuit 720, the diplexers (e.g., the first and second diplexers 724A, 724B as shown in FIG. 7A) allow signals and noise in the frequency band, e.g., 7-7.5GHz, to go through. In some implementations, in order to prevent any of the noise from leaking back to the quantum processing unit, the filter 804 in the example circuit module 800 can be used to protect the quantum processing unit from such noise. For example, the filter 804 operating in a frequency band of 6-6.8 GHz can be used to protect the quantum processing unit from the noise in the frequency band of 7-7.5 GHz. In some implementations, to prevent re-entry of signals with frequencies out of the frequency band of 7-7.5 GHz, the example circuit module 800 may include an additional low-order low-pass filter cascaded with the filter 804.

FIG. 9 is a block diagram showing aspects of an example diplexer 900. As shown in FIG. 9, the example diplexer 900 includes two hybrid couplers 902, e.g., a first hybrid coupler 902A and a second hybrid coupler 902B, and two filters 904, e.g., a first filter 904A and a second filter 904B. The example diplexer 900 may be implemented as the first and second diplexers 724A, 724B in the example microwave payload circuit 720 shown in FIG. 7A or in another manner. In some implementations, the example diplexer 900 may include additional and different features or components, and components of the example diplexer 900 may be implemented in another manner.

As shown in FIG. 9, each of the first and second hybrid couplers 902A, 902B is a four-port device. Specifically, the first hybrid coupler 902A includes a first input port 906-1A, a first isolated port 906-1B, a first output port 906-1C, and a second output port 906-1D; and the second hybrid coupler 902B includes a second input port 906-2A, a second isolated port 906-2B, a third output port 906-2C, and a fourth output port 906-2D.

In some implementations, the first and the second filters 904A, 904B can be identical. Each of the two filters 904A, 904B are coupled between the two hybrid couplers 902A, 902B. Specifically, as shown in FIG. 9, the first filter 904A is coupled between the first and second hybrid coupler 902A, 902B at the first output port 906-1C and the second input port 906-2A. The second filter 904B is coupled between the first and second hybrid coupler 902A, 902B at the second output port 906-1D and the second isolated port 906-2B. The first isolated port 906-1B and the third output port 906-2C are coupled to ground via respective resistors 908A, 908B. The example diplexer 900 shown in FIG. 9 is a four-port network (e.g., 906-1A, 906-1B, 906-2C, and 906-2D) with two of the ports (e.g., 906-1B, and 906-2C) terminated to the ground via the respective resistors 908A, 908B. In some instances, each of the resistors 908A, 908B has a resistance value of 50 ohm or another value.

As shown in FIG. 9, each of the first and second filters 904A, 904B is a band-pass filter designed to pass an input signal in a frequency band, e.g., 7-7.5 GHz, from the first input port 906-1A to the fourth output port 906-2D. An operational frequency band with -3 dB cutoff of the filters 904A, 904B can be slightly broader (e.g., ~ 6.8-7.7 GHz) than the frequency band of the input signal. In some implementations, a low-pass filter may be included in the example diplexer 900 to suppress the level of re-entrants, e.g., signals in higher harmonic bands with higher frequencies (e.g., 14-15 GHz). For example, each of the first and second filters 904A, 904B can be cascaded with a low-pass filter to maintain the main passband, eliminate all the re-entrants, and provide a large bandwidth cutoff. In some implementations, the first and second filters 904A, 904B may be fabricated on printed circuit board (PCB) containing surface mount components.

In some implementations, the example diplexer 900 can pass the input signal within the frequency band from the first input port 906-1A to the fourth output port 906-2D. During operation, when an input signal enters the first input port 906-1A of the first hybrid coupler 902A, it is split between the first and second output ports 906-1C, 906-1D with an equal power split and a 90-degree phase difference between the first output port 906-1C and second output port 906-1D. In some implementations, the first isolated port 906-1B may receive no signal. These can be designed to cover a range of bandwidths depending on the complexity of the design. Then split signals on the two respective ports 906-1C, 906-1D are passed by respective filters 904A, 904B. The signals at the ports 906-2A, 906-2B are then recombined in-phase by the second hybrid coupler 902B and outputs at the fourth output port 906-2D.

In certain implementations, the example diplexer 900 can also reject and dissipate a signal with frequencies out of the frequency band, for example, by the filters 904A, 904B, into the resistors 908A, 908B. During operation, when a pump signal with a frequency, e.g., ~6.5 GHz, enters the example diplexer 900 at the fourth output port 906-2D, the pump signal can be reflected by both of the filters 904A, 904B. In some instances, the pump signal may be reflected from the pump or may be caused by the finite directivity of a directional coupler (e.g., the directional coupler 802 of the example circuit module 800). In some implementations, the reflected portion of the pump signal may be determined by a rejection of the filters 904A, 904B, and the rejected pump signal is then dissipated in the resistor 908B at the third output port 906-2C of the second hybrid coupler 902B.

As shown in FIG. 9, the example diplexer 900, when used as the first diplexer 724A in the example microwave payload circuit 720, is coupled to a directional coupler (e.g., at the port 810A of the directional coupler 802 of the example circuit module 800 shown in FIG. 8) at the fourth output port 906-2D. In this case, the example diplexer 900 acts like an isolator which dissipates signals at all frequencies outside of the frequency band (e.g., 7-7.5GHz) in the third output port 906-2C. For signals with frequencies in the frequency band, the example diplexer 900 acts like a through in both directions (e.g., from the first input port 906-1A to the fourth output port 906-2D, and from the fourth output port 906-2D to the first input port 906-1A). In some implementations, allowing signals in the frequency band to pass from a TWPA (e.g., the TWPA 806 shown in FIG. 8) to the quantum processing unit (e.g., from the fourth output port 906-2D to the first input port 906-1A) should have minimal impact on the readout fidelity or the qubit conference time (T2). In some implementations, the example diplexer 900 when used as the first diplexer 724A in the example microwave payload circuit 720 is also able to provide a 50-ohm impedance match to the TWPA (e.g., the TWPA 806 shown in FIG. 8) because the second hybrid coupler 902B "buffers" the input impedance from the quantum processing unit, which is coupled to the first input port 906-1A of the first hybrid coupler 902A. In some implementations, the input impedance of the fourth output port 906-2D of the example diplexer 900 is well matched across the frequency band of the TWPA 806 shown in FIG. 8.

As shown in FIG. 9, the example diplexer 900, when used as the second diplexer 724B in the example microwave payload circuit 720, can be coupled to a TWPA (e.g., at the port 810E of the TWPA 806 of the example circuit module 800 shown in FIG. 8) at the first input port 906-1A. In this case, the second diplexer 724B can provide a 50-ohm impedance match to the TWPA 806 shown in FIG. 8 and protect the TWPA 806 and the quantum processing unit coupled to the first diplexer 724A from noise originated from the 4K thermal stage (e.g., 4K noise). In some implementations, this is accomplished at frequencies outside the frequency band (e.g., 7-7.5 GHz). When the 4K noise having a frequency outside the frequency band enters the fourth output port 906-2D of the second diplexer 724B and it is stopped by the reflective bandpass filters 904A, 904B and dissipated in the resistor 908B. When the 4K noise having a frequency in the frequency band enters the fourth output port 906-2D, the 4K noise may be passed through the second diplexer 724B, the circuit module 722 and the first diplexer 724A. In this case, the second diplexer 724B acts as an isolator to isolate signals with frequencies outside the frequency band. In certain instances, to recover this isolation in the 7-7.5 GHz band, a single junction isolator (e.g., the example isolator 1000 in FIG. 10) may be coupled to the fourth output port 906-2D of the second diplexer 724B or in another manner.

FIG. 10 is a block diagram showing aspects of an example isolator 1000. In some implementations, the example isolator 1000 can be used to provide isolation in a certain frequency range. For example, the example isolator 1000 is used to provide isolation in the frequency range of 7.0-7.5 GHz in the example microwave payload circuits 720, 750 shown in FIGS. 7A and 7B. As shown in FIG. 10, the example isolator 1000 is a single junction isolator. In some instances, the example isolator 1000 can provide a matching of less than 20 dB, an insertion loss of greater than 0.2 dB, an isolation of greater than 40 dB, and an operational frequency band of 6.8-7.8 GHz. In some instances, the example isolator 1000 is a cryogenic isolator. In some instances, the example isolator 1000 may be surface mount. In some implementations, the example isolator 1000 may include multiple single-junction isolators connected in series.

As shown in FIG. 10, the example isolator 1000 includes a circulator 1002 with three ports, e.g., ports 1006A, 1006B, and 1006C. As shown in FIG. 10, the port 1006A is an input port. In some implementations, the port 1006A can receive signals from a diplexer (e.g., the second diplexer 724B shown in FIG. 7A). In some implementations, the port 1006A may receive an amplified readout signal from a TWPA (e.g., the circuit module 722 shown in FIG. 7A). The port 1006B is an output port. The port 1006C is terminated to ground via a resistor 1004 with a resistance value equal to the impedance of the port 1006C. For example, the resistance value of the resistor 1004 is 50 ohm. As shown in the example isolator 1000, the arrow in the circulator 1002 indicates a circular direction of magnetic fields and the signal.

During operation, a signal is received at the port 1006A. When the port 1006B is well matched, the signal exits the circulator 1002 at the port 1006B at low loss. When the port 1006B is mismatched, the signal is reflected at the port 1006B, directed to the port 1006C, and absorbed by the resistor 1004, which is coupled between the port 1006C and ground. The port 1006C is an isolated port and is capable for handling the reflected signal from the port 1006B, providing protection to the port 1006A from the reflected signal in the reverse direction.

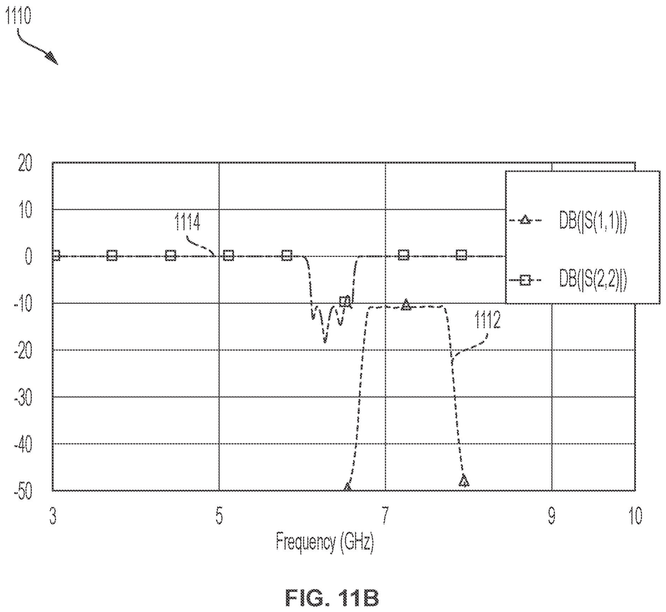

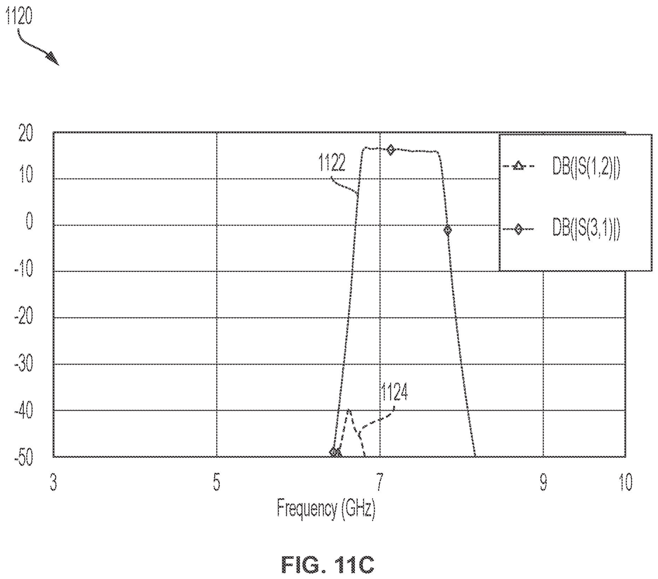

In some implementations, a microwave payload circuit including various subcircuits can be simulated, for example, using simulation software running on a computer system. The example microwave payload circuit 720 with ideal microwave circuit components can be simulated to validate the desired behavior at all three ports (e.g., 732, 734, and 736). The example microwave payload circuit 750 includes two diplexers 724A, 724B which can be implemented as the diplexer 900 shown in FIG. 9, a circuit module 722 which can be implemented as the circuit module 800 shown in FIG. 8, and an isolator 726 which may be implemented as the isolator 1000 shown in FIG. 10. The example microwave payload circuit 720 can be simulated using simulation software, such as AWR. Example simulation results are shown in FIGS. 11A, 11B, and 11C.

FIG. 11A is a plot 1100 showing simulated S-parameters of an example diplexer 900. Curve 1102 (S11) characterizes a reflection of an input signal at an input port (e.g., the first input port 906-1A) of the example diplexer 900. Curve 1104 (S21) characterizes a transmission of an input signal from the input port to an output port (e.g., the fourth output port 906-2D) of the example diplexer 900. As shown in FIG. 11A, the example diplexer 900 with ideal components acts like a filter and allows signals with frequencies in a frequency band of 6.8-8.0 GHz to pass as shown in the curve 1104 and remains well matched across the entire frequency band (e.g., 3-10 GHz) of the simulation as shown in the curve 1102. Rejected signals are dissipated in the resistors. Simulation of the example diplexer 900 shows an impedance matching across the entire TWPA band (e.g., at least within a frequency band of 5-8 GHz).

FIGS. 11B-11C are plots 1110 and 1120 showing simulated S-parameters of an example microwave payload circuit 720 shown in FIG.7A. Curve 1112 characterizes a reflection of a readout signal at a first input port (e.g., the input port 732) of the example microwave payload circuit 720. Curve 1114 characterizes a reflection of a pump signal at a pump port (e.g., the pump port 734) of the example microwave payload circuit 720. As shown in FIG. 11B, all three ports are well matched in their respective bands. Specifically, the first input port 732 corresponding to the first input port 906-1A of the diplexer 900 is well matched in the frequency band (e.g., 6.8-8.0 GHz) as shown in the curve 1112. The pump port 734 corresponding to the port 810F on the circuit module 800 is well matched in the frequency band (e.g., 6-6.7 GHz) of the filter 804 for the pump signal as shown in the curve 1114. The output port 736 corresponding to the port 1006B of the isolator 1000 is ideally matched across the entire band.

As shown in FIG. 11C, a transmission from the input port 732 to the output port 736 is observed in curve 1122, in which the transmission in the frequency band of 6.8-8.0 GHz is determined by the gain of the TWPA. As shown in FIG. 11C, no transmission is observed from the output port 736 to the input port 732. Curve 1124 characterizes a transmission of a signal from the input port 732 to the pump port 734. As shown in FIG. 11C, a transmission from the pump port 734 to the input port 732 at frequencies of ~6.8 GHz can be observed on the curve 1124.

Some of the subject matter and operations described in this specification can be implemented in digital electronic circuitry, or in computer software, firmware, or hardware, including the structures disclosed in this specification and their structural equivalents, or in combinations of one or more of them. Some of the subject matter described in this specification can be implemented as one or more computer programs, i.e., one or more modules of computer program instructions, encoded on a computer storage medium for execution by, or to control the operation of, data-processing apparatus. A computer storage medium can be, or can be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially generated propagated signal. The computer storage medium can also be, or be included in, one or more separate physical components or media.

Some of the operations described in this specification can be implemented as operations performed by a data processing apparatus on data stored on one or more computer-readable storage devices or received from other sources.

The term "data-processing apparatus" encompasses all kinds of apparatus, devices, and machines for processing data, including by way of example a programmable processor, a computer, a system on a chip, or multiple ones, or combinations of the foregoing. The apparatus can include special purpose logic circuitry, e.g., an FPGA (field programmable gate array) or an ASIC (application specific integrated circuit). The apparatus can also include, in addition to hardware, code that creates an execution environment for the computer program in question, e.g., code that constitutes processor firmware, a protocol stack, a database management system, an operating system, a cross-platform runtime environment, a virtual machine, or a combination of one or more of them.

A computer program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or data (e.g., one or more scripts stored in a markup language document), in a single file dedicated to the program, or in multiple coordinated files (e.g., files that store one or more modules, sub programs, or portions of code). A computer program can be deployed to be executed on one computer or on multiple computers that are located at one site or distributed across multiple sites and interconnected by a communication network.

Some of the processes and logic flows described in this specification can be performed by one or more programmable processors executing one or more computer programs to perform actions by operating on input data and generating output. The processes and logic flows can also be performed by, and apparatus can also be implemented as, special purpose logic circuitry, e.g., an FPGA (field programmable gate array) or an ASIC (application specific integrated circuit).

In a general aspect, parametric amplification is performed in a quantum computing system.

In a first example, a traveling wave parametric amplifier (TWPA) includes a plurality of Josephson junctions connected in series. The plurality of Josephson junctions includes a first Josephson junction, which includes a first superconducting electrode on a surface of a substrate, a second superconducting electrode that overlaps the first superconducting electrode, and a barrier sandwiched between overlapping sections of the first and second superconducting electrodes. The barrier defines a footprint with a tapered shape over the surface of the substrate.

Implementations of the first example may include one or more of the following features. The tapered shape is triangular. A base of the footprint overlaps a central region of the first superconducting electrode, and a central region of the second superconducting electrode overlaps an apex of the footprint. The barrier includes a first boundary side that defines a base of the footprint and does not contact the first or second superconducting electrodes; and second and third boundary sides that define tapered edges of the footprint and contact the second superconducting electrode. The TWPA further includes a transmission line that connects the plurality of Josephson junctions in series, wherein the first and second superconducting electrodes of the first Josephson junction are connected to the transmission line by respective superconducting patches. The TWPA further includes a pair of probe pads connected to the first Josephson junction. Each of the plurality of Josephson junctions includes a respective first superconducting electrode on the surface of the substrate, a respective second superconducting electrode that overlaps the respective first superconducting electrode, and a respective barrier sandwiched between overlapping sections of the first and second superconducting electrodes. The respective barrier defines a respective footprint with a tapered shape over the surface of the substrate. A portion of the first Josephson junction resides on the surface of the substrate, and each of the first superconducting electrode, the barrier, and the second superconducting electrode resides in contact with the surface. The footprint is a first footprint. The barrier at the portion of the first Josephson junction that is in contact with the surface of the substrate defines a second footprint on the surface of the substrate. The second footprint has a chevron shape. The first and second superconducting electrodes are formed on the surface of the substrate using a double-angled metal deposition method.

In a second example, a traveling wave parametric amplifier (TWPA) includes a plurality of Josephson junctions connected in series, and a pair of probe pads electrically coupled across one or more of the plurality of Josephson junctions. Each of the probe pads is electrically floating and are configured to interface with external testing probes.

Implementations of the second example may include one or more of the following features. Each of the probe pads includes a superconducting material. The TWPA further includes a transmission line that connects the plurality of Josephson junctions in series. The pair of probe pads is impedance-matched with an input impedance of the transmission line. The transmission line includes a coplanar waveguide, and the pair of probe pads is defined by a conductive layer of the TWPA. The plurality of Josephson junctions includes a first Josephson junction which includes a first superconducting electrode on a surface of a substrate, a second superconducting electrode that overlaps the first superconducting electrode, and a barrier sandwiched between overlapping sections of the first and second superconducting electrodes. The barrier defines a footprint with a tapered shape over the surface of the substrate. The first and second superconducting electrodes are formed on the surface of the substrate using a double-angled metal deposition process.

In a third example, a quantum computing system includes a qubit device and a TWPA in the first or the second example. The TWPA is configured to receive readout signals from the qubit device.

Implementations of the third example may include one or more of the following features. The quantum computing system includes a plurality of thermal stages in a dilution refrigerator. The TWPA and the qubit device reside at the lowest-temperature thermal stage of the plurality of thermal stages.

In a fourth example, a quantum computing system includes a qubit device, and a microwave payload circuit. The microwave payload circuit includes an input port coupled to the qubit device to receive readout signals from the qubit device, a first diplexer coupled to the input port at a first node of the microwave payload circuit, a circuit module coupled to the first diplexer at a second node of the microwave payload circuit, a second diplexer coupled to the circuit module at a third node of the microwave payload circuit, an isolator coupled to the second diplexer at a fourth node of the microwave payload circuit, and an output port coupled to the isolator at a fifth node of the microwave payload circuit.

Implementations of the fourth example may include one or more of the following features. The quantum computing system includes a substrate. The first diplexer, the circuit module and the second diplexer are disposed on the substrate. Each of the first diplexer and the second diplexer includes two couplers and two filters, and each of the two filters is coupled between the two couplers. The two couplers include a first coupler and a second coupler. The input port is connected to the first coupler at the first node, and the circuit module is connected to the second coupler at the second node. The two couplers includes a first coupler and a second coupler. The first coupler of the second diplexer and the parametric amplifier are coupled at the third node, the second coupler and the isolator are coupled at the fourth node. The circuit module includes a directional coupler, a parametric amplifier, and a filter. The microwave payload circuit further includes a pump port configured to provide a pump signal to the filter. The directional coupler includes a first output node connected to the parametric amplifier; and a second output node connected to the filter. The parametric amplifier comprises a traveling wave parametric amplifier (TWPA). The TWPA is the TWPA in the first or second examples. The quantum computing system includes a plurality of thermal stages. The qubit device resides at a first temperature thermal stage of the plurality of thermal stages, and the output port is configured to provide an output signal from the microwave payload circuit to a second, higher temperature thermal stage of the plurality of thermal stages.

In a fifth example, a readout signal from a qubit device in a quantum computing system is received at an input port of a first diplexer. In response to a frequency of the readout signal being in a first frequency band of the first diplexer, the readout signal from the input port is delivered to a circuit module that is coupled to the first diplexer. A pump signal is received from a pump source at a pump port of the circuit module. An amplified readout signal is delivered from the circuit module to a second diplexer that is coupled to the circuit module. In response to a frequency of the amplified readout signal being in a second frequency band of the second diplexer, the amplified readout signal is delivered from the second diplexer to an isolator that is coupled to the second diplexer. in response to an output port of the isolator being well-matched, the amplified readout signal is delivered to the output port.

Implementations of the fifth example may include one or more of the following features. The circuit module includes a directional coupler, a parametric amplifier, and a filter. The directional coupler is coupled to both the parametric amplifier and the filter. When the amplified readout signal is delivered, the readout signal is delivered through the directional coupler to the parametric amplifier; the pump signal is delivered through the filter to the directional coupler; by operation of the parametric amplifier, the readout signal and the pump signal are mixed and the amplified readout signal is generated; and the amplified readout signal is delivered to the second diplexer.

Implementations of the fifth example may include one or more of the following features. The first diplexer includes two couplers and two filters. Each of the two filters is coupled between the two couplers. The two couplers include a first coupler and a second coupler. The input port is connected to the first coupler at a first node, and the circuit module is connected to the second coupler at a second node. A leaked pump signal is received from the circuit module at the second coupler. When the leaked pump signal having a frequency that is out the first frequency band, the leaked pump signal is rejected by delivering the leaked pump signal from the second coupler to ground through a resistor. In response to the output port of the isolator being mismatched, the amplified readout signal is delivered from the second diplexer to a node of the isolator. The amplified readout signal is absorbed by operation of a resistor that is coupled between the node of the isolator and ground. The resistor has a resistance value equal to an input impedance of the node. A noise signal is received at the output port of the isolator. The noise signal is delivered from the output port to the node of the isolator. The noise signal is absorbed by operation of the resistor.

In a sixth example, a traveling wave parametric amplifier (TWPA) including a plurality of Josephson junctions connected in series is manufactured. The plurality of Josephson junctions includes a first Josephson junction. A first superconducting electrode of the first Josephson junction on a surface of a substrate is formed. A second superconducting electrode of the first Josephson junction that overlaps the first superconducting electrode is formed. A barrier between overlapping sections of the first and second superconducting electrodes is formed. The barrier defines a footprint with a tapered shape over the surface of the substrate.

Implementations of the sixth example may include one or more of the following features. The tapered shape is triangular. A base of the footprint overlaps a central region of the first superconducting electrode, and a central region of the second superconducting electrode overlaps an apex of the footprint. The barrier includes a first boundary side, second and third boundary sides. The first boundary side defines a base of the footprint and does not contact the first or second superconducting electrodes. The second and third boundary sides define tapered edges of the footprint and contact the second superconducting electrode.

Implementations of the sixth example may include one or more of the following features. Before the first superconducting electrode is formed, a transmission line that connects the plurality of Josephson junctions in series is formed. After the second superconducting electrode is formed, respective superconducting patches that connect the first and second superconducting electrodes of the first Josephson junction to the transmission line are formed. A pair of probe pads connected to the first Josephson junction is formed.

Implementations of the sixth example may include one or more of the following features. Respective first superconducting electrodes of the plurality of Josephson junctions are formed on the surface of the substrate. Respective second superconducting electrodes that overlap the respective first superconducting electrodes are formed. Respective barriers sandwiched between overlapping sections of the respective first and second superconducting electrodes are formed. The respective barriers define respective footprints over the surface of the substrate. A portion of the first Josephson junction resides on the surface of the substrate. Each of the first superconducting electrode, the barrier, and the second superconducting electrode resides in contact with the surface. The first and second superconducting electrodes are formed by performing a double-angled metal deposition process.

In a seventh example, a traveling wave parametric amplifier (TWPA) is manufactured. A plurality of Josephson junctions connected in series is formed. A pair of probe pads electrically coupled across one or more of the plurality of Josephson junctions is formed. Each of the probe pads is electrically floating and is configured to interface with external testing probes.

Implementations of the seventh example may include one or more of the following features. Each of the probe pads includes a superconducting material. When the pair of probe pads is formed, a transmission line that connects the plurality of Josephson junctions in series is formed. The pair of probe pads is impedance-matched with an input impedance of the transmission line. The transmission line includes a coplanar waveguide, and the pair of probe pads is defined by a conductive layer of the TWPA. The plurality of Josephson junctions includes a first Josephson junction. A first superconducting electrode of the first Josephson junction is formed on a surface of a substrate. A second superconducting electrode of the first Josephson junction that overlaps the first superconducting electrode is formed. A barrier sandwiched between overlapping sections of the first and second superconducting electrodes of the first Josephson junction is formed. The barrier defines a footprint with a tapered shape over the surface of the substrate. The first and second superconducting electrodes are formed by performing a double-angled metal deposition process.

While this specification contains many details, these should not be understood as limitations on the scope of what may be claimed, but rather as descriptions of features specific to particular examples. Certain features that are described in this specification or shown in the drawings in the context of separate implementations can also be combined. Conversely, various features that are described or shown in the context of a single implementation can also be implemented in multiple implementations separately or in any suitable sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the implementations described above should not be understood as requiring such separation in all implementations, and it should be understood that the described program components and systems can generally be integrated together in a single product or packaged into multiple products.

A number of embodiments have been described. Nevertheless, it will be understood that various modifications can be made. Accordingly, other embodiments are within the scope of the following claims.

The following represent embodiments according to the invention:
1. A traveling wave parametric amplifier (TWPA) comprising:
   a plurality of Josephson junctions connected in series, the plurality of Josephson junctions comprising a first Josephson junction comprising:
   a first superconducting electrode on a surface of a substrate;
   a second superconducting electrode that overlaps the first superconducting electrode; and
   a barrier sandwiched between overlapping sections of the first and second superconducting electrodes, the barrier defining a footprint over the surface of the substrate, the footprint having a tapered shape.
2. The TWPA of embodiment 1, wherein the tapered shape is triangular.
3. The TWPA of embodiment 1, wherein a base of the footprint overlaps a central region of the first superconducting electrode, and a central region of the second superconducting electrode overlaps an apex of the footprint.
4. The TWPA of embodiment 1, wherein the barrier comprises:
   a first boundary side that defines a base of the footprint and does not contact the first or second superconducting electrodes; and
   second and third boundary sides that define tapered edges of the footprint and contact the second superconducting electrode.
5. The TWPA of embodiment 1, comprising a transmission line that connects the plurality of Josephson junctions in series, wherein the first and second superconducting electrodes of the first Josephson junction are connected to the transmission line by respective superconducting patches.
6. The TWPA of embodiment 1, further comprising a pair of probe pads connected to the first Josephson junction.
7. The TWPA of embodiment 1, wherein each of the plurality of Josephson junctions comprises:
   a respective first superconducting electrode on the surface of the substrate;
   a respective second superconducting electrode that overlaps the respective first superconducting electrode; and
   a respective barrier sandwiched between overlapping sections of the first and second superconducting electrodes, the respective barrier defining a respective footprint over the surface of the substrate, the respective footprint having a tapered shape.
8. The TWPA of embodiment 1, wherein a portion of the first Josephson junction resides on the surface of the substrate, and each of the first superconducting electrode, the barrier, and the second superconducting electrode resides in contact with the surface.
9. The TWPA of embodiment 8, wherein the footprint is a first footprint, and the barrier at the portion of the first Josephson junction that is in contact with the surface of the substrate defines a second footprint on the surface of the substrate, the second footprint having a chevron shape.
10. The TWPA of embodiment 1, wherein the first and second superconducting electrodes are formed on the surface of the substrate using a double-angled metal deposition method.
11. A traveling wave parametric amplifier (TWPA) comprising
   a plurality of Josephson junctions connected in series; and
   a pair of probe pads electrically coupled across one or more of the plurality of Josephson junctions, each of the probe pads being electrically floating and configured to interface with external testing probes.
12. The TWPA of embodiment 11, wherein each of the probe pads comprises a superconducting material.
13. The TWPA of embodiment 11, comprising a transmission line that connects the plurality of Josephson junctions in series.
14. The TWPA of embodiment 13, wherein the pair of probe pads is impedance-matched with an input impedance of the transmission line.
15. The TWPA of embodiment 13, wherein the transmission line comprises a coplanar waveguide, and the pair of probe pads is defined by a conductive layer of the TWPA.
16. The TWPA of embodiment 11, wherein the plurality of Josephson junctions comprises a first Josephson junction comprising:
   a first superconducting electrode on a surface of a substrate;
   a second superconducting electrode that overlaps the first superconducting electrode; and
   a barrier sandwiched between overlapping sections of the first and second superconducting electrodes, the barrier defining a footprint over the surface of the substrate, the footprint having a tapered shape.
17. The TWPA of embodiment 16, wherein the first and second superconducting electrodes are formed on the surface of the substrate using a double-angled metal deposition method.
18. A quantum computing system comprising:
   a qubit device; and
   the TWPA of any preceding embodiment, the TWPA being configured to receive readout signals from the qubit device.
19. The quantum computing system of embodiment 18, comprising a plurality of thermal stages in a dilution refrigerator, wherein the TWPA and the qubit device reside at the lowest-temperature thermal stage of the plurality of thermal stages.
20. A quantum computing system comprising:
   a qubit device; and
   a microwave payload circuit comprising:
      an input port coupled to the qubit device to receive readout signals from the qubit device;
      a first diplexer coupled to the input port at a first node of the microwave payload circuit;
      a circuit module coupled to the first diplexer at a second node of the microwave payload circuit;
      a second diplexer coupled to the circuit module at a third node of the microwave payload circuit;
      an isolator coupled to the second diplexer at a fourth node of the microwave payload circuit; and
      an output port coupled to the isolator at a fifth node of the microwave payload circuit.
21. The quantum computing system of embodiment 20, comprising a substrate, wherein the first diplexer, the circuit module, and the second diplexer are disposed on the substrate.
22. The quantum computing system of embodiment 20, wherein each of the first diplexer and the second diplexer comprises two couplers and two filters, and each of the two filters is coupled between the two couplers.
23. The quantum computing system of embodiment 21, wherein the two couplers comprise a first coupler and a second coupler, the input port is connected to the first coupler at the first node, and the circuit module is connected to the second coupler at the second node.
24. The quantum computing system of embodiment 21, wherein the two couplers comprise a first coupler and a second coupler, the first coupler of the second diplexer and the parametric amplifier are coupled at the third node, the second coupler and the isolator are coupled at the fourth node.
25. The quantum computing system of embodiment 20, wherein the circuit module comprises a directional coupler, a parametric amplifier, and a filter, and the microwave payload circuit further comprises a pump port configured to provide a pump signal to the filter.
26. The quantum computing system of embodiment 25, wherein the directional coupler comprises:
   a first output node connected to the parametric amplifier; and
   a second output node connected to the filter.
27. The quantum computing system of embodiment 25, wherein the parametric amplifier comprises a traveling wave parametric amplifier (TWPA).
28. The quantum computing system of embodiment 27, wherein the TWPA is the TWPA of any one of embodiments 1 through 17.
29. The quantum computing system of embodiment 20, comprising a plurality of thermal stages, wherein the qubit device resides at a first temperature thermal stage of the plurality of thermal stages, and the output port is configured to provide an output signal from the microwave payload circuit to a second, higher temperature thermal stage of the plurality of thermal stages.
30. A method comprising:
   at an input port of a first diplexer, receiving a readout signal from a qubit device in a quantum computing system;
   in response to a frequency of the readout signal being in a first frequency band of the first diplexer, delivering the readout signal from the input port to a circuit module that is coupled to the first diplexer;
   at a pump port of the circuit module, receiving a pump signal from a pump source;
   delivering an amplified readout signal from the circuit module to a second diplexer that is coupled to the circuit module;
   in response to a frequency of the amplified readout signal being in a second frequency band of the second diplexer, delivering the amplified readout signal from the second diplexer to an isolator that is coupled to the second diplexer; and
   in response to an output port of the isolator being well-matched, delivering the amplified readout signal to the output port.
31. The method of embodiment 30, wherein the circuit module comprises a directional coupler, a parametric amplifier, and a filter, the directional coupler is coupled to both the parametric amplifier and the filter, and delivering the amplified readout signal comprises:
   delivering the readout signal through the directional coupler to the parametric amplifier;
   delivering the pump signal through the filter to the directional coupler;
   by operation of the parametric amplifier, mixing the readout signal and the pump signal and generating the amplified readout signal; and
   delivering the amplified readout signal to the second diplexer.
32. The method of embodiment 30, wherein the first diplexer comprises two couplers and two filters, and each of the two filters is coupled between the two couplers, the two couplers comprise a first coupler and a second coupler, the input port is connected to the first coupler at a first node, and the circuit module is connected to the second coupler at a second node, and the method comprises:
   at the second coupler, receiving a leaked pump signal from the circuit module, the leaked pump signal having a frequency that is out the first frequency band; and
   rejecting the leaked pump signal by delivering the leaked pump signal from the second coupler to ground through a resistor.
33. The method of embodiment 30, comprising:
   in response to the output port of the isolator being mismatched, delivering the amplified readout signal from the second diplexer to a node of the isolator; and
   absorbing the amplified readout signal by operation of a resistor that is coupled between the node of the isolator and ground, the resistor having a resistance value equal to an input impedance of the node.
34. The method of embodiment 33, comprising:
   at the output port of the isolator, receiving a noise signal;
   delivering the noise signal from the output port to the node of the isolator; and
   absorbing the noise signal by operation of the resistor.
35. A method of manufacturing a traveling wave parametric amplifier (TWPA) comprising a plurality of Josephson junctions connected in series, the plurality of Josephson junctions comprising a first Josephson junction, the method comprising:
   forming a first superconducting electrode oaf the first Josephson junction on a surface of a substrate;
   forming a second superconducting electrode of the first Josephson junction that overlaps the first superconducting electrode; and
   forming a barrier between overlapping sections of the first and second superconducting electrodes, the barrier defining a footprint over the surface of the substrate, the footprint having a tapered shape.
36. The method of embodiment 35, wherein the tapered shape is triangular.
37. The method of embodiment 35, wherein a base of the footprint overlaps a central region of the first superconducting electrode, and a central region of the second superconducting electrode overlaps an apex of the footprint.
38. The method of embodiment 35, wherein the barrier comprises:
   a first boundary side that defines a base of the footprint and does not contact the first or second superconducting electrodes; and
   second and third boundary sides that define tapered edges of the footprint and contact the second superconducting electrode.
39. The method of embodiment 35, comprising:
   prior to forming the first superconducting electrode, forming a transmission line that connects the plurality of Josephson junctions in series; and
   after forming the second superconducting electrode, forming respective superconducting patches that connect the first and second superconducting electrodes of the first Josephson junction to the transmission line.
40. The method of embodiment 35, comprising:
   forming a pair of probe pads connected to the first Josephson junction.
41. The method of embodiment 35, comprising:
   forming respective first superconducting electrodes of the plurality of Josephson junctions on the surface of the substrate;
   forming respective second superconducting electrodes of the plurality of Josephson junctions that overlaps the respective first superconducting electrodes; and
   forming respective barriers sandwiched between overlapping sections of the respective first and second superconducting electrodes of the plurality of Josephson junctions, the respective barriers defining respective footprints over the surface of the substrate, the footprints having tapered shapes.
42. The method of embodiment 35, wherein a portion of the first Josephson junction resides on the surface of the substrate, and each of the first superconducting electrode, the barrier, and the second superconducting electrode resides in contact with the surface.
43. The method of embodiment 35, wherein forming of the first and second superconducting electrodes comprises performing a double-angled metal deposition process.
44. A method of manufacturing a traveling wave parametric amplifier (TWPA), the method comprising:
   forming a plurality of Josephson junctions connected in series; and
   forming a pair of probe pads electrically coupled across one or more of the plurality of Josephson junctions, each of the probe pads being electrically floating and configured to interface with external testing probes.
45. The method of embodiment 44, wherein each of the probe pads comprises a superconducting material.
46. The method of embodiment 44, wherein forming the pair of probe pads comprises forming a transmission line that connects the plurality of Josephson junctions in series.
47. The method of embodiment 46, wherein the pair of probe pads is impedance-matched with an input impedance of the transmission line.
48. The method of embodiment 46, wherein the transmission line comprises a coplanar waveguide, and the pair of probe pads is defined by a conductive layer of the TWPA.
49. The method of embodiment 44, wherein the plurality of Josephson junctions comprises a first Josephson junction, and the method comprises:
   forming a first superconducting electrode of the first Josephson junction on a surface of a substrate;
   forming a second superconducting electrode of the first Josephson junction that overlaps the first superconducting electrode; and
   forming a barrier sandwiched between overlapping sections of the first and second superconducting electrodes of the first Josephson junction, the barrier defining a footprint over the surface of the substrate, the footprint having a tapered shape.
50. The method of embodiment 49, wherein forming the first and second superconducting electrodes comprises performing a double-angled metal deposition process.

## Claims

1. A quantum computing system comprising:
a qubit device; and
a microwave payload circuit comprising:
an input port coupled to the qubit device to receive readout signals from the qubit device;
a first diplexer coupled to the input port at a first node of the microwave payload circuit;
a circuit module coupled to the first diplexer at a second node of the microwave payload circuit;
a second diplexer coupled to the circuit module at a third node of the microwave payload circuit;
an isolator coupled to the second diplexer at a fourth node of the microwave payload circuit; and
an output port coupled to the isolator at a fifth node of the microwave payload circuit.

2. The quantum computing system of claim 1, comprising a substrate, wherein the first diplexer, the circuit module, and the second diplexer are disposed on the substrate.

3. The quantum computing system of claim 1, wherein each of the first diplexer and the second diplexer comprises two couplers and two filters, and each of the two filters is coupled between the two couplers.

4. The quantum computing system of claim 2, wherein the two couplers comprise a first coupler and a second coupler, the input port is connected to the first coupler at the first node, and the circuit module is connected to the second coupler at the second node.

5. The quantum computing system of claim 2, wherein the two couplers comprise a first coupler and a second coupler, the first coupler of the second diplexer and the parametric amplifier are coupled at the third node, the second coupler and the isolator are coupled at the fourth node.

6. The quantum computing system of claim 1, wherein the circuit module comprises a directional coupler, a parametric amplifier, and a filter, and the microwave payload circuit further comprises a pump port configured to provide a pump signal to the filter.

7. The quantum computing system of claim 6, wherein the directional coupler comprises:
a first output node connected to the parametric amplifier; and
a second output node connected to the filter.

8. The quantum computing system of claim 6, wherein the parametric amplifier comprises a traveling wave parametric amplifier (TWPA).

9. The quantum computing system of claim 8, wherein the TWPA is the TWPA of any one of claims 1 through 17.

10. The quantum computing system of claim 1, comprising a plurality of thermal stages, wherein the qubit device resides at a first temperature thermal stage of the plurality of thermal stages, and the output port is configured to provide an output signal from the microwave payload circuit to a second, higher temperature thermal stage of the plurality of thermal stages.

11. A method comprising:
at an input port of a first diplexer, receiving a readout signal from a qubit device in a quantum computing system;
in response to a frequency of the readout signal being in a first frequency band of the first diplexer, delivering the readout signal from the input port to a circuit module that is coupled to the first diplexer;
at a pump port of the circuit module, receiving a pump signal from a pump source;
delivering an amplified readout signal from the circuit module to a second diplexer that is coupled to the circuit module;
in response to a frequency of the amplified readout signal being in a second frequency band of the second diplexer, delivering the amplified readout signal from the second diplexer to an isolator that is coupled to the second diplexer; and
in response to an output port of the isolator being well-matched, delivering the amplified readout signal to the output port.

12. The method of claim 11, wherein the circuit module comprises a directional coupler, a parametric amplifier, and a filter, the directional coupler is coupled to both the parametric amplifier and the filter, and delivering the amplified readout signal comprises:
delivering the readout signal through the directional coupler to the parametric amplifier;
delivering the pump signal through the filter to the directional coupler;
by operation of the parametric amplifier, mixing the readout signal and the pump signal and generating the amplified readout signal; and
delivering the amplified readout signal to the second diplexer.

13. The method of claim 11, wherein the first diplexer comprises two couplers and two filters, and each of the two filters is coupled between the two couplers, the two couplers comprise a first coupler and a second coupler, the input port is connected to the first coupler at a first node, and the circuit module is connected to the second coupler at a second node, and the method comprises:
at the second coupler, receiving a leaked pump signal from the circuit module, the leaked pump signal having a frequency that is out the first frequency band; and
rejecting the leaked pump signal by delivering the leaked pump signal from the second coupler to ground through a resistor.

14. The method of claim 11, comprising:
in response to the output port of the isolator being mismatched, delivering the amplified readout signal from the second diplexer to a node of the isolator; and
absorbing the amplified readout signal by operation of a resistor that is coupled between the node of the isolator and ground, the resistor having a resistance value equal to an input impedance of the node.

15. The method of claim 14, comprising:
at the output port of the isolator, receiving a noise signal;
delivering the noise signal from the output port to the node of the isolator; and
absorbing the noise signal by operation of the resistor.
